# EUROPÄISCHE PATENTSCHRIFT

(11) **EP 0 791 929 B1**
(45) Veröffentlichungstag und Bekanntmachung des Hinweises auf die Patenterteilung: **27.11.2002**
(21) Anmeldenummer: 96114934.1
(22) Anmeldetag: 18.09.1996
(51) Int. Cl.: G11C 5/00, G11C 16/02, G06F 11/20, G11C 7/00

(54) **Elektronisches Gerät und Verfahren zu seiner Duplizierung und Einrichtung zur Datenübertragung zwischen zwei gleichartig aufgebauten elektronischen Geräten**
Electronic device and method of its duplication, and system for transferring data between two similar built electronic devices
Dispositif électronique et méthode de sa duplication et système de transfert de données entre deux dispositifs électroniques similaires

(30) Priorität: 24.02.1996 DE 19607101
(43) Veröffentlichungstag der Anmeldung: 27.08.1997
(73) Patentinhaber: Hella KG Hueck & Co., 59552 Lippstadt (DE); DaimlerChrysler AG, 70567 Stuttgart (DE)
(72) Erfinder: Braun, Fritz, 71394 Kernen (DE); Decius, Nikolaus, 59558 Lippstadt (DE); Finsterbusch, Joachim, 59557 Lippstadt (DE)

(56) Entgegenhaltungen:
- EP-A- 0 570 168
- DE-A- 3 807 519
- US-A- 4 700 292
- US-A- 4 937 732

## Beschreibung

Die Erfindung betrifft ein elektronisches Gerät mit einem Mikroprozessor oder Microcontroller, einem nichtflüchtigen Speicher und einer Schnittstelle, ein Verfahren zu seiner Duplizierung und eine Einrichtung zur Datenübertragung zwischen zwei gleichartig aufgebauten elektronischen Geräten.

In der DE 38 07 519 A1 ist eine Datensteuereinheit beschrieben, bei der die Datenübertragung zwischen zwei Systemen durch eine Datenübertragungs-Schnittstelle bewirkt wird, die mit einem Steuerteil versehen ist, wobei der Datenaustausch über einen Zweikanal-Speicher erfolgt.

Die US 4 700 292 beschreibt den Datenaustausch zwischen zwei datenverarbeitenden Systemen, wobei ein Prozessor als Master-Prozessor und ein zweiter Prozessor als Slave-Prozessor betrieben wird und der Datenaustausch mittels direkter Speicherzugriffe (direct memory access) erfolgt.

Aus der US 4 937 732 ist eine Bewässerungseinrichtung bekannt, bei dem festinstallierte mikroprozessorgesteuerte Geräte mittels eines tragbaren Moduls über eine Schnittstelle programmiert werden können.

Ein Gerät zur laufenden Überwachung des Betriebes eines Kraftfahrzeuges ist beispielsweise aus der deutschen Gebrauchsmusterveröffentlichung DE-U 88 16 458 bekannt.

Andere Geräte - beispielsweise für Steuerzwecke in Verkehrsmitteln, wie z.B. Kraftfahrzeuge, etwa zur Steuerung des Antriebstranges oder für Diagnosezwecke zur Ermittlung von Wartungsintervallen wurden bisher so ausgeführt, dass die Funktion auf einen ganz speziellen Bauzustand bzw. einer speziellen Ausführung der angeschlossenen Funktionseinheiten abgestimmt war. Bislang erfordern unterschiedliche Motor- oder Getriebeausführungen unterschiedliche Steuergeräte, was hinsichtlich der Logistik erhöhten Aufwand bedeutete.

Deshalb werden zunehmend sogenannte Einheitssteuergeräte entwickelt, die prinzipiell für eine Mehrzahl von angeschlossenen Funktionseinheiten geeignet sind. Die Anpassung an die jeweilige Funktionseinheit wird durch auswechselbare Parameter bewirkt. Die Parametrierung erfolgt dann entweder schon beim Hersteller des elektronischen Steuergerätes oder bei der Endmontage der betreffenden Funktionseinheit, z.B. des Antriebstranges oder des Gesamtfahrzeugs, d.h. im Applikationsumfeld.

Im allgemeinen geschieht dies dadurch, daß von einer Recheneinheit, z.B. einem PC oder einer Workstation über eine Rechnerschnittstelle die Parametersätze auf das Steuergerät initial übertragen werden. Wenn jedoch ein Gerät später im Fahreinsatz ausfällt, muß von der instandsetzenden Werkstatt in gleicher Weise ein identischer Parametersatz wieder auf ein Ersatzgerät übertragen werden. Dies bedeutet aber, daß dafür gesorgt werden muß, daß den Werkstätten im Bedarfsfalle die entsprechenden Urparametersätze zur Verfügung stehen, was einen erheblichen datenlogistischen Aufwand involviert.

Ein entsprechendes Gerät kann beispielsweise auch zur Überwachung von Betriebsparametern einer Einrichtung vorgesehen sein, wobei diese Parameter regelmäßig durch den Mikroprozessor in den nichtflüchtigen Speicher eingeschrieben werden, z.B. bei einem Unfalldatenschreiber oder bei einem elektronischen Fahrtenschreiber in einem Verkehrsmittel. Ein wiederum anders beschaffenes Gerät kann z.B. dazu vorgesehen sein, um Inspektionsintervalle von der tatsächlichen Belastung eines Verkehrsmittels oder von Bauteilen abhängig zu machen und kann, insbesondere bei kostspieligen Inspektionen von größeren Verkehrsmitteln erhebliche Kosten einsparen. Bei einem solchen Gerät kann z.B. der aufgelaufene Kilometerstand abgespeichert werden.

Man kann sich in diesem Falle zwar damit behelfen, daß in regelmäßigen Abständen - z.B. bei einem routinemäßigen Service oder bei einem Tankaufenthalt - die Daten ausgelesen und in einem stationären Rechner gespeichert werden. Im Bedarfsfalle kann dann auf diese "aktuellen" Datensatz zugegriffen werden. Es bleibt jedoch das logistische Problem, da der Ausfall des betreffenden elektronischen Geräts an einem ganz anderen Ort geschehen kann als die Speicherung. Auch ist dieser Datensatz dann nur relativ aktuell, da der steuergeräteinterne Datensatz sich permanent verändern kann. Dies ist besonders dann der Fall, wenn in einem elektronischen Gerät Parametersätze durch adaptive Anpassung laufend verändert werden. etwa in einem Bremssteuergerät.

Besonders problematisch ist, wenn ein solches Gerät ausfällt oder durch eine äußere Einwirkung so weitgehend zerstört wird, daß selbst dann, wenn der nichtflüchtige Speicherbaustein noch intakt ist, die Nutzdaten nicht mehr oder nur noch unter hohem Aufwand erreichbar sind. Denn oft ist der Speicherbaustein nicht ohne weiteres entnehmbar, weil solche Geräte meistens gekapselt sind oder weil der Speicherbaustein als SMD-Bauteil sogar fest eingelötet und nur äußerst schwierig zerstörungsfrei entfernbar ist.

Sollen die in einem vorhandenen Gerät gespeicherten Daten identisch in einem Erstzgerät nutzbar gemcht werden, so sind hierfür üblicherweise speziell aufgebaute Diagnosegeräte im Gebrauch, welche aber aus Kostengründen nicht in jeder Werkstatt zu finden sind. Diese bekannten Geräte verlangen jedoch, daß der Mikroprozessor des Gerätes, aus dem Daten entnommen werden sollen, noch einwandfrei funktioniert. Diese Funktion ist aber auch nur dann gewährleistet, wenn in dem betreffenden Gerät auch alle Mittel, die die Betriebsspannung des Mikroprozessorts aufbereiten bzw. bereitstellen, noch vollumfänglich betriebsfähig sind. Selbst wenn all diese Anforderungen erfüllt sind, ist die Übertragung der Daten von einem beispielsweise teildefekten Gerät zu einem entsprechenden Diagnosegerät und anschließend von dem Diagnosegerät in das Ersatzgerät mit erheblichem Aufwand verbunden.

Es ist daher Aufgabe der Erfindung, ein besonders einfach und kostengünstig aufgebautes elektronisches Gerät mit Mikroprozessor oder Microcontroller und einem nichtflüchtigen Datenspeicher zu schaffen, das den im Falle seines Defektwerdens und Ersatzerfordernisses aufzubietenden Logistik-, Zeit- und Geräteaufwand in Grenzen hält. Die Nutzbarmachung (noch) gespeicherter Daten in einem gleichartigen Gerät soll mit minimalen Aufwand sicher ermöglicht werden.

Diese Aufgabe wird auf einfache und vorteilhafte Weise durch ein gattungsgemäßes elektronisches Gerät mit den kennzeichnenden Merkmalen des Anspruchs 1 gelöst.

Die Erfindung macht sich die Erkenntnis zunutze, daß Defekte von elektronischen Steuergeräten fast immer durch den selektiven Ausfall einzelner Elemente wie elektronische Bauteile, galvanische Verbindungen oder mechanische Bauteile verursacht sind, und daß nur in ganz seltenen Fällen der eigentliche Datenspeicher, der ein EEPROM, Flash-EPROM oder dgl. sein kann, tatsächlich beschädigt wird bzw. ist. In den meisten Fällen ist die gespeicherte Information im Prinzip noch erhalten. Lediglich der Zugriffspfad zu dieser Information ist direkt oder indirekt blockiert.

Deshalb wird vorgeschlagen, ein elektronisches **Gerät,** etwa Steuergerät, so aufzubauen bzw. seine Hardware so zu gestalten, daß Steuer- und Datenleitungen und Leitungen zur Stromversorgung des Speicherbausteins nicht nur zu den mit ihm kooperierenden, internen Elektronikelementen des Steuergerätes - also jedenfalls zu seinem Mikroprozessor oder Microcontroller - geführt werden, sondern darüberhinaus auch noch direkt oder über besondere Schnittstellenmittel an von außen zugängliche Kontakte, z.B. eine Steckereinheit, geführt werden und der Speicherbaustein über diese Schnittstelle von außen jedenfalls von den übrigen Elektronikelementen entkoppelt sowohl stromversorgbar als auch betreibbar, nämlich auslesbar, gemacht wird. Durch wenige Mittel wird ermöglicht, daß bei Verbindung der identischen Schnittstellen eines ersten und eines zweiten elektronischen Gerätes miteinander und bei Betriebsspannungsversorgung des ersten Gerätes der Inhalt des nichtflüchtigen Speichers des zweiten Gerätes in den nichtflüchtigen Speicher des ersten Gerätes zwangsläufig kopierbar ist.

Durch einfaches Zusammenschalten der Schnittstellen zweier gleichartig aufgebauter Geräte können so leicht die im nichtflüchtigen Speicherbaustein enthaltenen Daten eines Gerätes auf den nichtflüchtigen Speicherbaustein eines anderen Gerätes übertragen werden.

Hierbei ist besonders vorteilhaft, daß bei dem auszulesenden Gerät im wesentlichen nur der nichtflüchtige Speicher, die Schnittstelle und eine Ventilstrecke (im Hinblick auf ihre Sperrwirkung) funktionstüchtig zu sein brauchen, über welche der Speicher normalerweise stromversorgt wird. Dagegen ist die Funktionsfähigkeit des Mikroprozessors oder der Spannungsversorgung des betreffenden Gerätes völlig unerheblich. Insbesondere kann das auszulesende Gerät einen defekten Mikroprozessor aufweisen.

Vorteilhaft ist also, daß das Gerät, dessen Speicher ausgelesen werden soll, weitestgehend funktionsunfähig sein kann. Es muß auch nicht aus einer eigenen Stromversorgung bestromt werden. Es kann deshalb als Ursache seines Ausfalles auch einen schweren zentraler Defekt, beispielsweise an seinem Spannungsregler oder zentralen Siebmitteln der Stromversorgung, aufweisen. Nur der nichtflüchtige Speicher des elektronischen Geräts und im wesentlichen ein Halbleiterventil und wenige Leitungen an eine Schnittstelle müssen noch intakt sein, wobei die Schnittstelle bloß auf Kontakte reduziert sein kann.

Nach dem Ablauf des automatischen Auslesens der Daten enthält das auslesende Gerät den vollständigen Datensatz des auszulesenden Speichers im anderen Gerät, so daß es sofort als Ersatzgerät eingebaut werden kann. Ebenso gut kann vorgesehen werden, daß die in das auslesende Gerät eingespeicherten Daten an anderer Stelle ausgewertet werden, ohne daß hierfür das Originalgerät benötigt wird.

Weitere vorteilhafte Ausgestaltungen und Weiterbildungen der Erfindung gehen aus den Unteransprüchen hervor.

So kann eine steuerbare Schalteinrichtung zur Bewerkstelligung einer Freischaltung von mit dem auszulesenden Speicherbaustein normalerweise kooperierenden Bauelementen vorgesehen werden.

Bei einer solchen Fortbildung erweist es sich als vorteilhaft, wenn der Schaltzustand der Schalteinrichtung durch ein an der Schnittstelle anliegendes logisches Signal gesteuert werden kann.

Besonders vorteilhaft ist es, wenn dieses Signal aus einer dem Gerät durch ein weiteres gleichartig aufgebautes Gerät über die Schnittstelle zugeführten Betriebsspannung gewonnen wird. Das weitere Gerät versorgt dabei die zur Datenübertragung erforderlichen Bausteine des Gerätes - und zwar unabhängig davon, ob eine Versorgung des Gerätes über dessen eigene Betriebsspannungsanschlüsse noch möglich wäre - und legt gleichzeitig durch Steuerung des Schaltzustandes der Schalteinrichtung des Gerätes fest, daß das Gerät bei der Datenübertragung das datensendende und es selbst das datenempfangende Gerät ist.

Ein besonders einfacher Aufbau der Schalteinrichtung und der Schnittstelle des erfindungsgemäßen Gerätes ist gegeben, wenn die Bausteine als Signalleitungen jeweils eine einzelne Datenleitung und eine Taktsignalleitung aufweisen. Die Datenübertragung erfolgt in diesem Falle seriell und synchron. Selbstverständlich umfaßt die Erfindung auch die Möglichkeit eines asynchronen und/oder parallelen Datenaustausches, was dann allerdings mit einem aufwendigeren Aufbau des Gerätes verbunden ist.

Weiterhin ist es vorteilhaft, daß die Schalteinrichtung zweierlei Schaltmittel aufweist, nämlich erste Schaltmittel, welche die mindestens eine Signalleitung des Mikroprozessors in Vorzugslage mit denen des nichtflüchtigen Speichers und bei Aktivierung mit denen der Schnittstelle verbinden, wobei der aktive Schaltzustand der ersten Schaltmittel durch ein Spannungssignal des Mikroprozessors gesteuert wird, und daß zweite Schaltmittel vorgesehen sind, welche es ermöglichen, die mindestens eine Signalleitung vom nichtflüchtigen Speicher und der Schnittstelle miteinander zu verbinden und gleichzeitig die mindestens eine Signalleitung des Mikroprozessors von diesen Bausteinen abzukoppeln. Dieser Schaltzustand hängt von einem logischen Signal der Schnittstelle ab oder auch davon, ob die Schalteinrichtung (und der nichtflüchtige Speicher) ihre Betriebsspannung von einer über die Schnittstelle zugeführten Betriebsspannung erhalten oder über die eigenen Beriebsspannungsversorgungsleitungen. In erstgenanntem Schaltzustand kann der nichtflüchtige Speicher über die Schnittstelle ausgelesen werden.

Besonders vorteilhaft sind auch andere Fortbildungen der Erfindung, die gänzlich ohne derlei Schaltmittel auskommen. Sie nutzen aktiv das Ausgangsisolationsverhalten neuerer digitaler Bauelemente bei Wegfall ihrer Betriebsspannung in Kombination mit einem bestimmten, von Boot-Programm gesteuerten Verhalten des Mikroprozessors in seiner Initialisierungsphase aus. Der hardwaremäßige Aufwand schrumpft dabei auf ein absolutes Minimum.

In vorteilhafter Weise erkennt der Mikroprozessor im Zuge seines Initialisierungslaufs (sog. Booten) die Hardwareerweiterung und nutzt sie anschließend zur Bewirkung des vollautomatischen Datenübertragungs- bzw. Parametriervorganges bezüglich seines nichtflüchtigen Speichers. In diesem Zusammenhang kann die Trennung der Verbindung zwischen den beiden Geräten vorteilhaft ausgenutzt werden, um die Abspeicherung des im Arbeitsspeicher (RAM) des auslesenden Mikroprozessors zwischengespeicherten Daten aus dem ausgelesenen nichtflüchtigen Speicher im anderen Gerät in den nichtflüchtigern Speicher des auslesenden Geräts auszulösen.

Wenn von außen ein entsprechendes Gerät mit Mikroprozessor und nichtflüchtigem Speicher in entsprechender Umgebungsbeschaltung an die Schnittstelle eines zu programmierenden bzw. zu parametrierenden Gerätes angekoppelt wird, greift der Mikroprozessor des letzteren auf vorgenannten Speicher im zu ersetzenden bzw. zu duplizierenden Gerät zwangsläufig zu und bootet sich - je nach Programmierung sogar unter Verwendung dort abgelegter Daten - zwangsläufig bis zur Lesefähigkeit hoch und liest die Daten aus. Beispielsweise ein im nichtflüchtigen Speicher grundsätzlich mitabgespeicherte/s und dabei miteingelesene/s Instruktion oder Flag-Bit kann zur Zurückspeicherung dieser Daten aus einem vorbestimmten RAM-Bereich des Mikroprozessors in den nichtflüchtigen Speicher genutzt werden, nachdem eine Trennung der Verbindung zwischen beiden Geräten vollzogen ist. Die durch diese Trennung ausgelöste Zurückspeicherung im stromversorgten Gerät geschieht daraufhin zwangsläufig in den eigenen nichtflüchtigen Speicher, der dadurch überschrieben und zu einer Kopie des ausgelesenen wird.

Das erfindungsgemäße elektronische Gerät besitzt also insgesamt die Fähigkeit, über eine Datenleitung Programmdaten bzw. Parameter - wie z.B. Lebenslaufdaten - aus dem Speicher eines anderen - zu duplizierenden - Geräts gleichen Typs zu übernehmen, und zwar gleichgültig, ob letzteres funktionsfähig ist oder nicht. Auch im Falle seiner Funktionsfähig braucht das zu duplizierende Gerät nicht (wie normal) von einer externen Betriebsspannungsquelle aus mit Strom versorgt zu werden.

Gemäß dem abhängigen Anspruch 21 kann die Schnittstelle außer Kontakten mit diesen kooperative Mittel umfassen, welche einen unbeabsichtigten und/oder unbefugten Zugang zu letzteren unmöglich machen.

Gemäß dem abhängigen Anspruch 22 ist das Gehäuse des elektronischen Gerätes einerseits in Bezug auf besagte Schnittstelle (Kontakte und kooperative Mittel) - und vice versa - und andererseits in Bezug auf ein zweites identisches Gerät und dessen Schnittstelle (Kontakte und kooperative Mittel) - und vice versa - so ausgebildet, daß die beiden Schnittstellen nur und nur durch Zusammenstecken der beiden Geräte zu einer einzigen einkörperlich-funktionalen Einrichtung zur Datenübertragung verbindbar sind.

Diesem Detail kommt überragende Bedeutung zu, weil es dazu beiträgt, die unbefugte Generation von identischen elektronischen Geräten per Manipulation unmöglich zu machen - trotz bzw. im Lichte der extrem einfachen Kopierbarkeit des erfindungsgemäßen elektronischen Geräts.

Eine weitere Aufgabe der Erfindung ist, ein **Verfahren** vorzuschlagen, mittels dessen ein solcherart jungfräuliches oder aber schon beliebig anders programmiertes elektronisches Gerät gemäß dem in einem entsprechend anderen Gerät nichtflüchtig abgelegten Daten- bzw. Parametersatz "dupliziert" werden kann.

Diese Aufgabe wird auf überraschend einfache und vorteilhafte Weise durch die erfindungsgemäßen Merkmale gemäß Anspruch 23 gelöst.

Dem gemäß werden in einem ersten Schritt zwei Geräte A und B mit unbeaufschlagten Versorgungsklemmen mittels ihrer Schnittstellen miteinander verbunden. Sollen Daten aus dem Gerät B in das Gerät A übertragen werden, dann wird in einem zweiten Schritt das Gerät A an seinen normalen Versorgungsklemmen mit seiner normalen Betriebsspannung beaufschlagt, nicht jedoch das Gerät B. In einem dritten Schritt wird der nichtflüchtige Speicherbaustein des Gerätes A durch dessen Bestromung initial zunächst zwangsläufig deaktiviert und der nichtflüchtige Speicherbaustein des Gerätes B sofort zwangsläufig aktiviert. In einem vierten Schritt erkennt der Mikroprozessor des Gerätes A am sofortigen Aktiviertsein eines nichtflüchtigen Speicherbausteins, daß es sich dabei nicht um den eigenen noch inaktiv gehaltenen handelt und wird infolgedessen veranlaßt, im nichtflüchtigen Speicherbaustein des Gerätes B liegende Daten in seinen RAM-Bereich einzulesen. In einem fünften Schritt wird (vom Bediener) abgewartet, bis der Mikroprozessor des Gerätes A nach dem Abschluß des Auslesevorganges zur Überwachung eines Signalpegels übergegangen ist, welcher Signalpegel spätestens dann über die Schnittstelle hinweg vom Gerät B im Gerät A in charakteristischer Weise zwangsläufig verursacht wird, um dadurch die Präsenz bzw. Nichtpräsenz des Gerätes B dem Mikroprozessor anzuzeigen. In einem sechsten Schritt wird daraufhin - unter Aufrechterhaltung der Stromversorgung des Gerätes A - an der Schnittstelle die elektrische Verbindung zwischen den beiden Geräte A und B aufgehoben. In einem siebten Schritt wird diese elektrische Trennung aufgrund der vorgenannten Pegelüberwachung sensiert und vom Mikroprozessor des Gerätes A als Wahrheitsbedingung ausgewertet für das nun mögliche Zurückschreiben der zuvor von ihm in seinen RAM-Bereich eingelesenen Daten in den einzigen noch vorhandenen nichtflüchtigen Speicherbaustein, nämlich den des Gerätes A. In einem achten Schritt wird das Einschreiben der Daten in den vorgenannten nichtflüchtigen Speicherbaustein initiiert, durchgeführt und (vom Bediener) abgewartet, bis dieser Einschreibvorgang beendet ist.
Optional kann noch in einem neunten Schritt abgewartet werden, bis sich der Mikroprozessor neu gestartet hat und/oder bis der Mikroprozessor die Applikation des Gerätes A normal hochgebootet und das Gerät insoweit Betriebsbereitschaft erreicht hat.
In einem optionalen zehnten Schritt kann schließlich beim vorgenannten Bootvorgang der Applikation auch noch die Richtigkeit der stattgefundenen Datenübertragung geprüft werden.
In einem optional elften Schritt kann aus dem Erreichen der normalen Betriebsbereitschaft des Gerätes A das Abgeschlossensein und/oder die Richtigkeit der erfolgten Datenübertragung erkannt werden.

Im Zuge dieses Verfahrens wird der Datentransfer überaus einfach durch eine sehr einfache Erweiterung des Bootstraps des Mikroprozessors (erweitert um zustandsabhängige Portabfragen) gesteuert.

Alles in allem übernimmt insoweit ein neues Gerät A die nichtflüchtig abgespeicherten Daten eines alten Geräts B, bzw. letzteres "vererbt" seine Daten zwangsläufig an das neue Gerät A weiter. Im Hinblick auf ein Verkehrsmittel ist es so beispielsweise gewährleistet, daß das neue Gerät A bezüglich gespeicherter Fahrzeugparameter und Lebenslaufdaten auf absolut demselben Stand ist wie das alte Gerät B. Es kann somit ein nahtloser Weiterbetrieb mit aufgelaufenen Parametern erfolgen. Ersatzlogistik entfällt komplett.

Dieses Verfahren besticht durch seine nicht mehr zu überbietende Einfachheit sowie dadurch, daß allein der Anschluß der Betriebsspannung (an A oder B) darüber entscheidet, von welchem Gerät aus Daten in das jeweils andere Gerät transferiert werden. Das erfindungsgemäße Verfahren eigent sich also sehr gut zum Clonen von Geräten für Anwendungen, für die wenigstens ein einziges brauchbares bzw. geeignetes Mustergerät bereits vorliegt, worauf der Anspruch 27 gerichtet ist.

Vorteilhaft ist ferner, daß gemäß Anspruch 28 aus zwei erfindungsgemäß aufgebauten elektronischen Geräten leicht eine Einrichtung zusammengeschaltet werden kann, bei der eine vollautomatisch ablaufende Datenübertragung vom nichtflüchtigen Speicher eines Gerätes auf den nichtflüchtigen Speicher des anderen Gerätes erfolgen kann, wobei die Richtung der Datenübertragung leicht und unverwechselbar festlegbar ist.

Eine solche Einrichtung kann auch vorteilhaft ein zeitoptimiertes Datenübertragungsverfahren realisieren, in dem die Daten von einem zum anderen Gerät blockweise übertragen werden und der Mikroprozessor bereits während der Schreibzeit eines Datenblocks in dem zu beschreibenden nichtflüchtigen Speicher, bereits den nächsten Datenblock aus dem zu lesenden nichtflüchtigen Speicher ausliest.

Drei Ausführungsbeispiele der Erfindung sind in der Zeichnung dargestellt und werden nachfolgend näher beschrieben.
Es zeigen:
- **Fig. 1**: ein Verbindungsschaltbild zweier erfindungsgemäßer, zum Datentransfer bereiter elektronischer Geräte A und B - insoweit auch als Einrichtung zur Datenübertragung zu verstehen -, wie zur Durchführung des erfindungsgemäßen Verfahrens benötigt;
- **Fig. 2**: ein Wirkschaltbild eines ersten Ausführungsbeispiels eines erfindungsgemäßen Gerätes, welches eine steuerbare Schalteinrichtung verwendet;
- **Fig. 3**: eine Konkretisierung des in Fig. 1 dargestellten Verbindungschaltbildes unter Zugrundelegung des Wirkschaltbildes gemäß Fig. 2;
- **Fig. 4**: eine andere Konkretisierung des in Fig. 1 dargestellten Verbindungschaltbildes unter Zugrundelegung des Wirkschaltbildes eines zweiten Ausführungsbeispiels, welches ohne steuerbare Schalteinrichtung auskommt;
- **Fig. 5**: eine weitere Konkretisierung des in Fig. 1 dargestellten Verbindungschaltbildes unter Zugrundelegung eines gegenüber Fig. 4 modifizierten Wirkschaltbildes des dritten Ausführungsbeispiels, welches eine besonders einfache Lösung im Falle der Verwendung eines A/D-Microcontrollers ermöglicht.

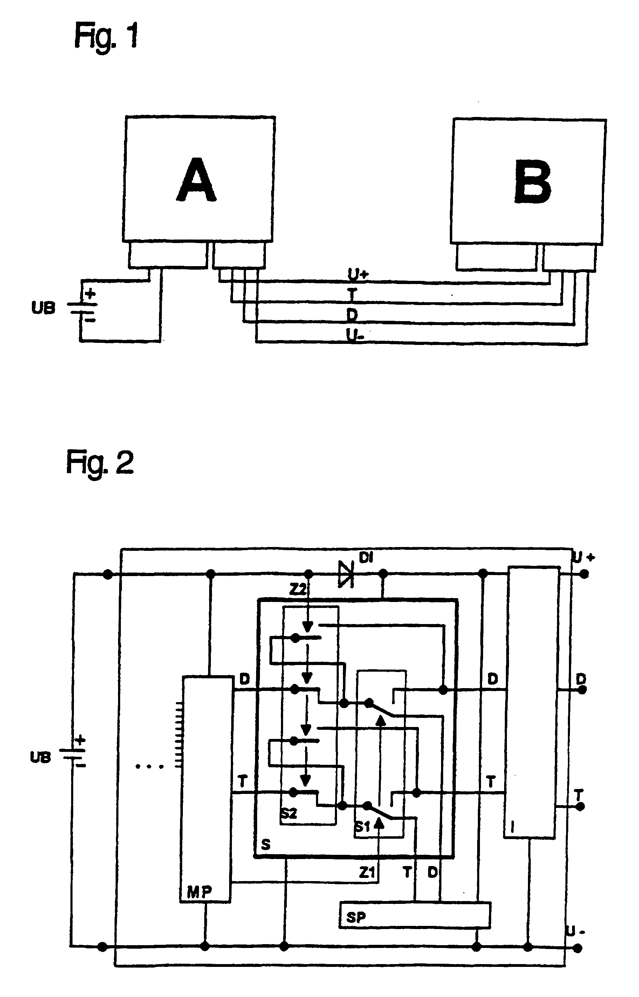

**Fig. 1** zeigt zwei erfindungsgemäße Steuergeräte A und B, welche zum Zwecke der nichtflüchtigen Einspeicherung von im Gerät B nichtflüchtig abgelegten Daten in das Gerät A miteinander und mit einer Betriebsspannungsquelle UB verbunden sind. Beide Geräte sind gleichartig beschaffen. Es fällt demgegenüber auf, daß zwar das Gerät A, welches nach dem Datenübertragungsvorgang ein "Duplikat" des Gerätes B (ggfs. vor seinem Defekt) sein soll, mit der Betriebsspannungsquelle UB verbunden ist, während beim Gerät B als Datenquelle eine solche Versorgung fehlt. Die Verbindung der beiden Geräte untereinander geschieht hier beispielhaft über nur vier Leiteradern, nämlich eine Ader (U+) zur Führung einer positiven Spannung, aus der der nichtflüchtige Speicher im Gerät B versorgbar ist, einer entsprechenden Ader (U-), welche normalerweise die Funktion einer Masseleitung haben kann, einer weiteren Ader (D) zur seriellen Übertragung von Daten und einer weiteren Ader (T) zur Übertragung eines Taktsignales für z.B. eine synchrone Übertragung.

Dieses Verbindungsschaltbild gilt für die ersten beiden Ausführungsbeispiele identisch und sinngemäß modifiziert auch für das dritte Ausführungsbeispiel und versinnbildlicht auch die gerätetechnische Konfiguration zur Durchführung des erfindungsgemäßen Verfahrens sowie die Einrichtung zur Datenübertragung.

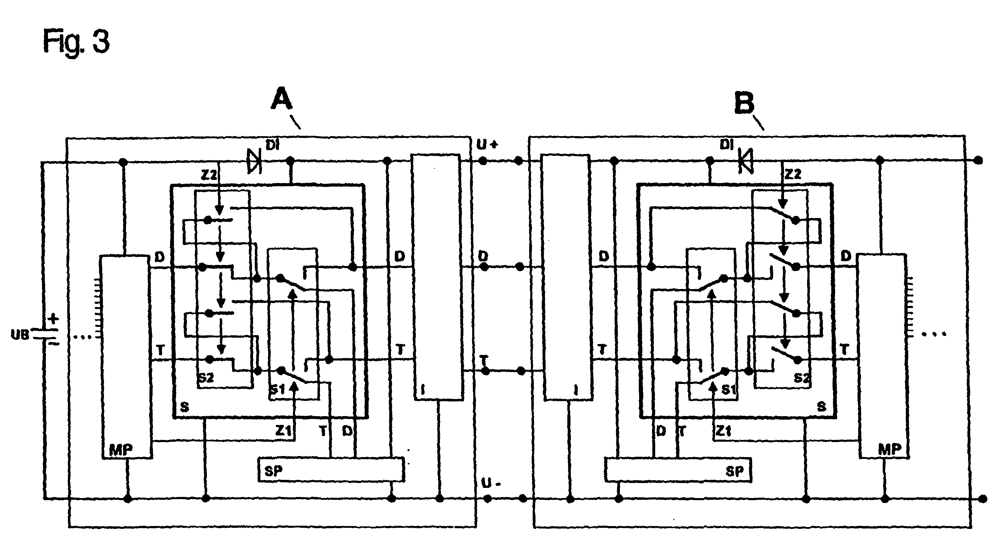

**Fig. 2** zeigt ein Wirkschaltbild des ersten Ausführungsbeispiels eines erfindungsgemäßen Gerätes, wobei in der Zeichnung - in Art eines Auszugs - nur erfindungswesentliche Schaltungsteile dargestellt sind. Nicht dargestellt sind zum Beispiel Bausteine oder Sensoren, welche Signale oder Daten an den Mikroprozessor (MP) abgeben, aus denen dieser wiederum Daten generiert, welche er über die Schalteinrichtung (S) in den nichtflüchtigen Speicher (SP) einschreibt. Nicht dargestellt sind ferner alle übrigen Bauteile des Gerätes, welche ebenfalls aus der Versorgungsspannungsquelle UB ihre Betriebsenergie beziehen.

Das Gerät enthält zumindest folgende Bausteine: den Mikroprozessor (MP), einen nichtflüchtigen Speicher (SP) und eine Schnittstelle (I). Jeder dieser Bausteine (MP; SP, I) weist Signalleitungen auf, in diesem Beispiel jeweils eine Taktsignalleitung (T) zur Synchronisation und eine serielle Datenleitung (D).

Die Signalleitungen (D, T) dieser Bausteine (MP, SP, I) sind über eine Schalteinrichtung (S) miteinander verbindbar, wobei die Schalteinrichtung mittels erster Schaltmittel (S1) und zweiter Schaltmittel (S2) die Signalleitungen (D, T) von jeweils zwei der drei Bausteinen (MP, SP, I) miteinander verbinden kann.

Der Schaltzustand der ersten Schaltmittel (S1) kann durch eine erste Zugriffssteuerleitung (Z1) vom Mikroprozessor (MP) beeinfluß werden, welcher so festlegt, ob er auf den nichtflüchtigen Speicher (SP) oder auf die Schnittstelle (I) zugreift.

Der Schaltzustand der zweiten Schaltmittel (S2) wird über die zweite Zugriffssteuerleitung (Z2) bestimmt und hängt davon ab, ob die Schaltung über die eigenen Spannungsversorgungsleitungen von der Betriebsspannungsquelle (UB) oder statt dessen von der über die Schnittstelle (I) geführte externe Betriebsspannung (U+, U-) versorgt wird.

Im letztgenannten Fall versorgt die externe Betriebsspannung (U+, U-) nur die Schalteinrichtung (S) und den nichtflüchtigen Speicher (SP). Wegen der sperrenden Diode (DI) gelangt kein positives Potential an die Zugriffssteuerleitung (Z2) und wegen des ebenfalls nicht mit Spannung versorgten Mikroprozessors (MP) auch nicht an die Zugriffssteuerleitung (Z1). Hierdurch nimmt die Schalteinrichtung (S) einen Schaltzustand ein, bei welchem sie den nichtflüchtigen Speicher (SP) mit der Schnittstelle (1) verbindet, wodurch der nichtflüchtige Speicher (SP) mittels der über die Schnittstelle (I) geführten Signalleitungen (D, T) ausgelesen werden kann(dieser Schaltzustand ist in der **Fig. 3**, Gerät B dargestellt).

Die Schnittstelle (1) ist als bidirektionale Treiberschaltung ausgeführt und besitzt zudem eine Schutzschaltung gegen auf das Gerät einwirkende schädliche Spannungseinflüsse.

Die Schalteinrichtung (S) kann leicht durch einen handelsüblichen integrierten Analogschalter oder auch durch Tristate-Gatter realisiert werden.

Die **Fig. 2** zeigt die Schalteinrichtung (S) in einem für den normalen Betrieb üblichen Schaltzustand, bei dem die Signalleitungen (D, T) des Mikroprozessors (MP) mit denen des nichtflüchtigen Speichers (SP) verbunden sind und der Mikroprozessor (MP) auf den nichtflüchtigen Speicher (SP) lesend und schreibend zugreift.

Das in **Fig. 2** dargestellte elektronische Gerät ermöglicht besonders gut eine Datenübertragung auf ein gleichartig aufgebautes Gerät. Das Prinzipschaltbild einer hierzu geeigneten Einrichtung zeigt **Fig. 1.**

Zwei gleiche oder gleichartig aufgebaute Geräte (A, B) sind mittels ihrer Schnittstellenleitungen (U+, U-, D, T) miteinander verbunden. Nur das Gerät (A) ist an eine Spannungsquelle (UB) angeschlossen. Die für die Datenübertragung benötigten Bauelemente des Gerätes (B) werden mit der Betriebsspannung (B) des Gerätes (A) über die Diode (DI), die Schnittstelle (I) und die Schnittstellenleitungen U+, U-) versorgt.

Durch diese Beschaltung ist gleichzeitig festgelegt, daß das Gerät (A) das aktive, die Datenübertragung steuernde Gerät ist, welches Daten einliest, und das Gerät (B) das auszulesende Gerät darstellt.

Die Einrichtung zur Übertragung von Daten zwischen zwei elektronischen Geräten wird im Blockschaltbild in **Fig. 3** weiter konkretisiert. Ersichtlichermaßen sind hierbei zwei Geräte (A, B) spiegelbildlich mittels ihrer Schnittstellenleitungen (U+, U-, D, T) zusammengeschaltet.

Beide Geräte (A, B) sind gleichartig aufgebaut; sofern sie sich überhaupt unterscheiden, dann nur bezüglich in der **Fig. 3** nicht dargestellter Baugruppen. Zur Vereinfachung sind in beiden Geräten jeweils gleiche Bauelemente auch mit gleichen Bezugszeichen versehen worden.

Die Betriebsspannungsquelle (UB) versorgt sämtliche Bausteine (MP, SP, I) sowie auch die Schalteinrichtung (S) des Gerätes (A) und legt zudem die Zugriffssteuerleitung (Z2) fest auf positives Potential, wodurch sich die Schaltmittel (S2) des Gerätes (A) in dem in der Zeichnung dargestellten Schaltzustand befinden, in welchem die Signalleitungen (D, T) des Mikroprozessors (MP) mit den ersten Schaltmitteln (S1) verbunden sind.

Die Betriebsspannung (UB) gelangt weiter über die Diode (DI) und die Schnittstelle (I) des Gerätes (A) und die Schnittstellenleitung (U+, U-) sowie über die Schnittstelle (I) des Gerätes (B) auch an die Spannungsanschlüsse des nichtflüchtigen speichers (SP) und der Schalteinrichtung (S) des Gerätes (B).

Durch die sperrende Diode (DI) gelangt das positive Potential nicht zur Zugriffssteuerleitung (Z2) und auch nicht zum Mikroprozessor (MP) des Gerätes (B) und somit auch nicht an die Zugriffssteuerleitung (Z1) des Gerätes (B). Hierdurch wird die Schalteinrichtung des Gerätes (B) fest in den in **Fig. 3** dargestellten Schaltzustand versetzt, bei welchem die Signalleitungen (D, T) des nichtflüchtigen Speichers (SP) fest mit der Schnittstelle (I) des Gerätes (B) verbunden sind. Über die Schnittstellenleitungen (D, T) hat somit auch die Schnittstelle (I) des Gerätes (A) eine direkte Verbindung zu den Signalleitungen des nichtflüchtigen Speichers (SP) des Gerätes (B). Der Mikroprozessor (MP) des Gerätes (A) steuert nun über die Zugriffssteuerleitung (Z1) die ersten Schaltmittel (S1) jeweils abwechselnd in einen Schaltzustand, in welchem die Signalleitungen (D, T) des Mikroprozessors (MP) mit denen der Schnittstelle (I) verbunden sind und so der Mikroprozessor (MP) von der Schnittstelle (I) Daten einlesen kann und danach jeweils in einen Schaltzustand, bei welchem die Signalleitungen (D, T) des Mikroprozessors (MP) mit denen des nichtflüchtigen Speichers (SP) des Gerätes (A) verbunden sind, wobei der Mikroprozessor (MP) die zuvor eingelesenen Daten in diesen nichtflüchtigen Speicher (SP) einschreibt.

So wird auf einfache Weise der vollständige Datensatz, welcher im nichtflüchtigen Speicher (SP) des Gerätes (B) enthalten ist, in den nichtflüchtigen Speicher (SP) des Gerätes (A) kopiert. Nach Abschluß dieses Vorganges kann Gerät (A) unmittelbar als Ersatzgerät für ein eventuell teildefektes Gerät (B) zur Anwendung kommen.

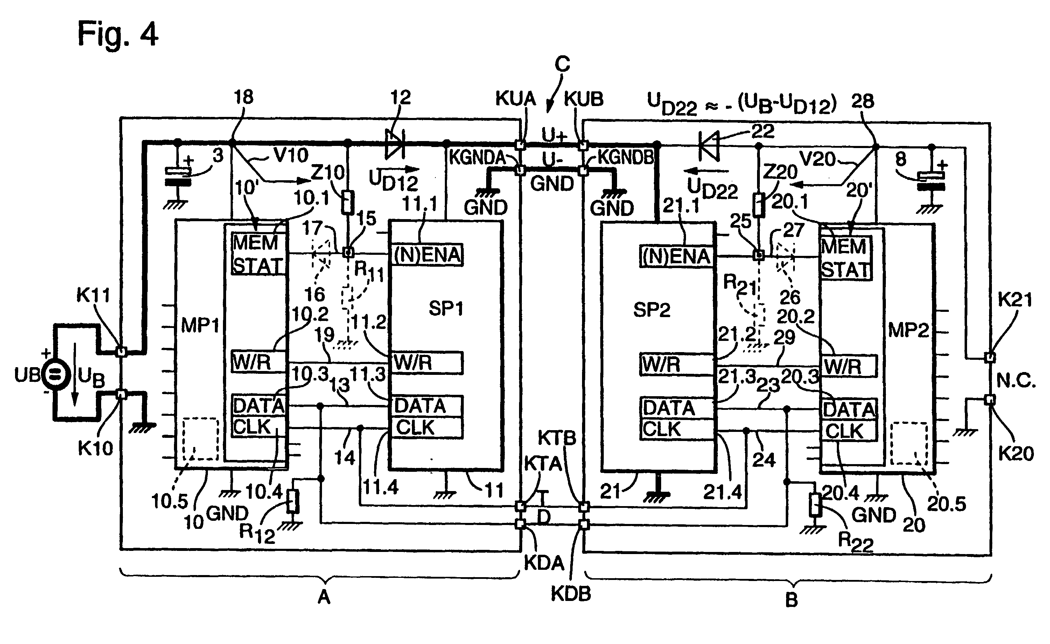

Gemäß einem zweiten Ausführungsbeispiel nach Fig. 4 besitzen zwei hinsichtlich ihrer nichtflüchtigen Speicherorganisation identischen Geräte A, B jeweil einen Mikroprozessor oder Microcontroller 10 bzw. 20 mit Ports (Ein- und Ausgängen) 10' bzw. 20' in "Advanced Tristate-" oder "Power-Activated-Port-Technology". U.a. ist hier im Rahmen von 10' bzw. 20' ein bidirektionaler Port 10.1 bzw. 21.1 (MEM STATUS; MEMSTAT), einen Lese-/Schreibsteuerausgang 10.2 bzw. 20.2 (WRITE/READ; W/R), ein bidirektionaler Datenport 10.3 bzw. 20.3 (DATA) und ein Taktausgang 10.4 bzw. 20.4 (CLOCK; CLK) vorgesehen. Der Mikroprozessor oder Microcontroller 10 bzw. 20 kann ferner über einen internen Speicherbereich 10.5 bzw. 20.5 verfügen, der vorteilhaft ein RAM und ein ROM zur Aufnahme wenigstens eines Rumpfteiles seines Bootprogramms umfassen kann. Um Fehldeutungen vorzubeugen, wird an dieser Stelle darauf hingewiesen, daß im Rahmen der gesamten nachfolgenden Beschreibung der Begriff "Mikroprozessor" auch durch den Begriff "Microcontroller" ersetzt werden kann, letztwelcher wie einschlägig bekannt sowohl über analoge als auch digitale Ein- und/oder Ausgänge und die hierfür benötigten A/D- bzw. D/A-Konversionsmittel verfügen kann.

Ohne Beschränkung der Allgemeinheit kann der Mikroprozessor oder Microcontroller 10 bzw. 20 auch mit externen RAMund/oder ROM-Bausteinen kooperieren; der Übersichtlichkeit halber sind solche in der Zeichnung nicht dargestellt. Die entsprechende Struktur des Gerätes A bzw. B hängt jedenfalls von seiner Anwendung, dem Umfang abzuarbeitender Programme und dem benutzten Mikroprozessor ab. Wenn nachfolgend also vom RAM/ROM des Mikroprozessors oder Microcontrollers die Rede ist, können darunter im Rahmen der Erfindunmg gleichwohl entsprechende interne und/oder externe Speicherbereiche verstanden werden.

Das Gerät A bzw. B verfügt weiter über einen nichtflüchtigen Speicherbaustein 11 bzw. 21 mit jeweils einem Inhibit- bzw. Disable-Eingang 11.1 bzw. 21.1 (NOT ENABLE; NENA) in entsprechender Technologie (Je nach Logik kann es sich bei diesem Eingang 11.1 bzw. 20.1 auch um einen Enable-Eingang (ENABLE; ENA) handeln, etwa bei Negativlogik, weshalb dieser Eingang in der Zeichnung mit (N)ENA bezeichnet ist). Der Speicherbaustein 11 bzw. 21 weist außer dem schon erwähnten Eingang 11.1 bzw. 21.1 noch einen Eingang 11.2 bzw. 21.2 (WRITE/READ; W/R), einen bidirektionalen Datenport 11.3 bzw. 21.3 (DATA; DATA) und einen Takteingang 11.4 bzw. 21.4 (CLOCK) auf.

Es sind die Ports 10.1 und 11.1 über einen Punkt 15 hinweg durch eine Leitung 17 und die Ports 20.1 und 21.1 über einen Punkt 25 hinweg durch eine Leitung 27, die Ports 10.2 und 11.2 durch eine Leitung 19 und die Ports 20.2 und 21.2 durch eine Leitung 29, die Ports 10.3 und 11.3 durch eine Datenleitung 13 und die Ports 20.3 und 21.3 durch eine Datenleitung 23 und die Taktports 10.4 und 11.4 durch eine Taktleitung 14 und die Taktports 20.4 und 21.4 durch eine Taktleitung 24 miteinander wirkverbunden.

Die Ports 10' bzw. 20' des Mikroprozessors 10 bzw. 20 zeichnen sich in "Advanced Tristate-" bzw. "Power-Activated-Port-Technology" dadurch aus, daß auch sie bei fehlender Betriebsspannung U_{B} in definierter Weise hochohmig und insoweit als Bürdelast praktisch vernachlässigbar sind. Der nichtflüchtige Speicherbaustein 11 bzw. 21 ist so beschaffen, daß seine Takt- und Daten-Ein- bzw. Ausgänge im Inhibit- oder Disable-Zustand hochohmig und als Bürdelast ebenfalls praktisch vernachlässigbar sind.

Genau wie beim ersten Ausführungsbeispiel liegt auch hier der Speicherbaustein 11 bzw. 21 nicht unmittelbar, sondern über ein in Versorgungsstromflußrichtung gepoltes, vorgeschaltetes Ventil 12 bzw. 22 an der geräteinternen Versorgungsspannungschiene 18 bzw. 28, die hier der Einfachheit halber direkt mit der Versorgungsklemme K11 bzw. K21 des Gerätes A bzw. B verbunden und durch einen Energiespeicher 3 bzw. 8 (Kondensator) gestützt ist (Normalerweise kann zwischen dem Energiespeicher 3 bzw. 8 und der Klemme 11 bzw. 21 natürlich noch ein Spannungsregler liegen; dieses Detail ist hier jedoch unerheblich. Von der Versorgungsspannungsschiene 18 bzw. 28 werden außer dem Mikroprozessor 10 bzw. 20 über abzweigende Versorgungsstränge V10 bzw. V20 auch noch übrige Bauteile des Gerätes Abzw. B mit Betriebsstrom versorgt.

An der Versorgungsspannungsschiene 18 bzw. 28 kann nun z.B. ein Widerstand oder eine Stromquelle Z10 bzw. Z20 liegen, welcher/e andererseits mit dem obengenannten Punkt 15 bzw. 25 und insoweit mit dem (N)ENA-Eingang 11.1 bzw.21.1 des Speicherbausteins 11 bzw. 21 verbunden ist. Von besagtem Punkt 15 bzw. 25 aus kann des weiteren optional ein (ggfs. relativ hochohmiger) Widerstand R₁₁ bzw. R₂₁ nach Masse geschaltet sein. Beispielhaft ist hier ferner noch ein (in der Praxis ebenfalls relativ hochohmiger) Widerstand R₁₂ bzw. R₂₂ von der Datenleitung 13 bzw. 23 nach Masse GND geschaltet.

Die erwähnte Wirkverbindung zwischen den Ports 10.1 und 11.1 bzw. 20.1 und 21.1 kann sowohl durch eine durchgehenden Leiterpfad oder über ein weiteres Ventil 16 bzw. 26 führend realisiert sein, welches bezüglich seiner Flußrichtung so gepolt ist, daß der Mikroprozessor 10 bzw. 20 den Eingang 11.1 bzw 21.1 des betreffenden Speicherbausteins 11 bzw. 21 prozessorintern nach Masse GND schalten kann.

Im Gerät A bzw. B sind jeweils der Versorgungsanschluß des Speicherbausteins 11 bzw. 21, die Gerätemasse GND, sowie Verbindungen mit den Datenleitungen 13 bzw. 23 und Taktleitungen 14 bzw. 24 an entsprechende Kontakte KUA bzw. KUB und KGNDA bzw. KGNDB und KDA bzw. KDB und KTA bzw KTB geführt.

Zum Zwecke einer Datenübertragung werden die jeweils erstgenannten Kontakte des Gerätes A mit den zweitgenannten Kontakten des (zu ersetzenden bzw. zu kopierenden bzw. zu vervielfältigenden) Gerätes B entweder direkt oder aber mittels eines speziellen Verbindungskabels oder eines Adapters C miteinander verbunden, welches bzw. welcher hier beispielhaft vier Pfade U+, U-/GND, T und D aufweist.

Im Gegensatz zum ersten Ausführungsbeispiel ist hier kein elektronischer Schnittstellenbaustein vorgesehen.

Dies kann sehr vorteilhaft sein, weil nicht nur irgend ein Defekt im Gerät B, sondern in Strenge auch ein Defekt eines wie auch immer beschaffenen Schnittstellenbausteins (I) gemäß dem ersten Ausführungsbeispiel die Auslesbarkeit der Daten aus dem noch intakten nichtflüchtigern Speicher (SP) bzw. 21 des Gerätes B in das Gerät A selbstverständlich auch unmöglich machen kann.

Im Rahmen der Erfindung können stattdessen die Geräte A und B ganz gezielt so ausgebildet und insbesondere bezüglich der Gestaltung ihrer physikalischen Schnittstelle und insbesondere deren Kontakte bzw. deren Form in Bezug aufeinander und bezüglich deren Zugänglichkeit so ausgebildet werden, daß sich zwei Geräte A und B an besagter Schnittstelle auch oder ausschließlich - entweder vermittels eines ganz speziellen Adapters (z.B. in Form eines Zwischensteckmoduls oder Kopierkabels) oder nur und nur unmittelbar - miteinander verbinden bzw. zusammenstecken lassen. Vorzugsweise enthält ein entsprechender Adapteralso keine aktiven Halbleiterbauteile, allenfalls in besonderen Fällen spannungsbegrenzende Schutzelemente beliebiger Art.

Die Erfindung umfaßt in diesem Lichte also auch, daß die Schnittstelle außer bloßen Kontakten - etwa KUA, KGNDA, KTA, KDA; möglicherweise auch noch KCA - mit diesen kooperative Mittel umfaßt, welche einen unbeabsichtigten oder unbefugten Zugang zu letzteren unmöglich machen. Diese Mittel können mechanischer Art und/oder einstückig mit dem Gehäuse des Geräts verbunden sein. Im Zusammenhang damit umfaßt die Erfindung ferner, daß ein elektronisches Gerät A ein äußeres Gehäuse aufweist, welches einerseits in Bezug auf seine Schnittstelle, also etwa Kontakte KUA, KGNDA, KTA, KDA, möglicherweise auch KCA und kooperative Mittel, - und vice versa - und andererseits in Bezug auf ein zweites identisches elektronisches Gerät B und dessen Schnittstelle, umfassend Kontakte KUB, KGNDB, KTB, KDB, möglicherweise auch KCB und kooperative Mittel, - und vice versa - so ausgebildet ist, daß die beiden Schnittstellen nur und nur durch Zusammenstecken der beiden Geräte A und B, d.h. an ein- und demselben Ort - zu einer einzigen einkörperlich-funktionalen Einrichtung zur Datenübertragung miteinander verbindbar sind.

Ohne Beschränkung der Allgemeinheit fällt eine solche, wie auch immer gestaltete Ausbildung der physikalischkörperlich nach außen in Erscheinung tretenden Schnittstelle sowie ggfs. auch in Abstimmung darauf die äußere Gestaltung der Gehäuse zweier identischer Geräte A und B in Bezug aufeinander in den Rahmen der Erfindung.

Eine solche Ausbildung kann nicht nur eine unbeabsichtigte Beschädigung der Elektronik des Gerätes A bzw. B durch unbeabsichtigte Einwirkungen insbesondere auf die Kontakte KTA und KTB bzw. KDA und KDB unmöglich machen oder zumindest erheblich erschweren. Sie erschwert auch in sehr wirksamer Weise Manipulation und Mißbrauch.

Das Gerät A bzw. B funktioniert - für sich allein bzw. in Verbindung mit dem jeweils anderen Gerät - wie folgt.

Der Widerstand bzw. die Stromquelle Z10 bewirkt unmittelbar nach dem Anlegen der Versorgungsspannung U_{B} an den Klemmen K10 und K11 den Pegel "H" am Eingang 11.1 des Speicherbausteins 11, wodurch dieser initial gesperrt und wenigstens einer seiner Ports 11.3 (bidirektionaler Daten-Port) und 11.4 (Takteingang) hochohmig geschaltet wird. Dadurch nimmt beispielsweise der Datenport 11.3 - ggfs. unterstützt durch den hochohmigen Widerstand R₁₂ - den logischen Pegel "L" an.

### Normalbetrieb des Gerätes A bzw. B allein

Im Normalbetriebsfall - ohne das Gerät B - frägt der ROM-Bootstrap des Mikroprozessors 10 den Pegel "H" an seinem Port 10.1 ab und frägt dann bzw. in Konjunktion damit beispielsweise den vorgenannten Initial-Pegel "L" an seinem Datenport 10.3 ab, d.h. das Freigeschaltetsein der Datenleitung 13. Dies geschieht beispielsweise durch überwachte Ausgabe eines Testsignals an seinem Datenport 10.3. Eine entsprechend positive Abfrage interpretiert der Mikroprozessor als "Normalbetrieb".

(Der ROM-Bootstrap ist wenigstens derjenige Teil der Initialisierungssoftware des Mikroprozessors in der jeweils vorliegenden Geräteapplikation, welcher die Ports, d.h. Ein- und Ausgänge des Mikroprozessors wenigstens abfragbar macht.)

Selbstverständlich kann bei geeigneter Programmierung des Bootstraps des Mikroprozessors und des Taktausganges 10.4 eine entsprechende Abfrage alternativ oder zusätzlich auch an dessen Taktausgang 10.4 erfolgen, insbesondere dann, wenn hierfür einm bidirektionaler Port des Mikroprozessors genutzt wird.

Wenn das Freigeschaltetsein der Leitung 13 (und/oder der Leitung 14) vom Mikroprozessor 10 erkannt worden ist (10.1 = "H" und/oder 10.3 bzw. 10.4 = "L") , erkennt der Mikroprozessor 10 daraus den "Normalzustand", zieht seinen MEMSTAT-Port 10.1 auf den Pegel "L", wodurch erstens der nichtflüchtige Speicher 11 aktiviert und zweitens das Weiterbooten unter Zugriff auf eben diesen Speicher 11 ausgelöst wird, bis der Mikroprozessor 10 die gesamte Geräteapplikation schließlich geladen hat und der Normalbetrieb des Gerätes A beginnt. Entsprechendes gilt umgekehrt für das Gerät B für sich allein genommen, wenn es nicht defekt ist.

### Clone-Betrieb "Dupliziere B"

Um Daten aus dem nichtflüchtigen Speicher eines Gerätes B in den nichtflüchtigen Speicher eines Gerätes A zu übertragen, werden beide Geräte gemäß **Fig. 1** miteinander verbunden.

Wie aus Fig. 4 im Detail ersichtlich, bleiben dabei die Kontakte K20 und K21 des Gerätes B unverbunden, während an die Kontakte K10 und K11 des Gerätes A die Betriebsspannung U_{B} angelegt wird. Ohne Betriebsspannung an den Kontakten K20 und K21 kann wegens Sperrens des Ventils 22 die Versorgungschiene 28 als an Masse GND liegend betrachtet werden, zumal der Speicher 23 nicht aufladbar ist bzw. z.B. sogar einen Kurzschluß haben kann, sofern es sich beim Gerät B um ein nicht mehr funktionsfähiges handelt.

Nach dem Anschließen der Betriebsspannung U_{B} an den Klemmen K10 und K11 wird auch hier das Gerät A bis auf seinen nichtflüchtigen Speicherbaustein 11 mit der Versorgungsspannung U_{B} und - über das Ventil 12 im Gerät A - sowohl sein nichtflüchtiger Speicherbaustein 11 als auch der nichtflüchtige Speicherbaustein 21 im Gerät B mit einer Betriebsspannung U+ =(U_{B}-U_{D12}) versorgt.

Der Widerstand bzw. die Stromquelle Z10 bewirken auch in diesem Falle unmittelbar nach dem Anlegen der Versorgungsspannung U_{B} an den Klemmen K10 und K11 den Pegel "H" am Punkt 15 und somit am Eingang 11.1 des Speicherbausteins 11, wodurch dieser wie beschrieben initial gesperrt und seine Ports 11.3 und 11.4 hochohmig geschaltet werden.

Im Gerät B kann der Widerstand oder die Stromquelle Z20 den Punkt 25 jedoch nicht auf Pegel "H" anheben, weil wegen die Versorgungsschiene 28 an Masse GND liegt (da U_{D22} = -(U_{B}-U_{D12} ). Am (N)ENA-Eingang 21.1 des Speicherbausteins 21 liegt somit Pegel "L", d.h. der Speicherbaustein 21 ist dauerhaft aktiviert. Dessen Datenleitung 23 und Taktleitung 24 ist jedoch über einen entsprechenden Schnittstellenpfad D bzw. T mit der entsprechenden Datenleitung 13 und Taktleitung 14 im Gerät A galvanisch verbunden. Da der Mikroprozessor 20 nicht stromversorgt ist, kann sein W/R-Ausgang 20.2 den W/R-Eingang 21.2 des Speicherbausteins 21 nicht auf Pegel "H" setzen, was vorliegend einer Ansteuerung des Speicherbausteins 21 zum Auslesen entspricht.

Auch hier frägt der Mikroprozessors 10 zunächst den Pegel "H" an seinem MEMSTAT-Port 10.1 ab und prüft im Anschluß daran oder in Konjunktion damit das Freigeschaltetsein seiner Ports 10.3 und/oder 10.4 ab als Voraussetzung für das oben beschriebene weitere normale Hochbooten der Applikation des Gerätes A.

Da der Speicher 21 jedoch aktiv geschaltet ist, verläuft diese Abfrage jetzt negativ. Dieses Ergebnis interpretiert der Mikroprozessor 10 als Instruktion zum Verlassen seiner normalen Boot-Routine zwecks Überschreiben aktueller Daten im nichtflüchtigen Speicherbausteins 11 mit Daten des/eines externen nichtflüchtigen Speicherbausteins 21 (Go to Clone-Verzweigung im Bootstrap des Prozessors).

Folglich setzt der Mikroprozessor 10 seinen Port 10.1 nicht auf Pegel "L", hält dadurch die Deaktivierung des Speicherbausteins 11 weiterhin aufrecht, bricht den normalen Boot-Vorgang im Zustand erreichter Ein- und Auslesefähigkeit ab und liest wenigstens den mit Daten belegten Inhalt des Speicherbausteins 21 in sein RAM ein.

Die (Ur-) Programmierung jedes nichtflüchtigen Speicherbausteins 11, 21, etc. kann als letztes auslesbares Bit z.B. den Pegel "H" vorsehen (Flag-Bit). Dadurch kann erreicht werden, daß die Datenleitung 23 am Schluß des Auslesens den Pegel "H" führt (Last Bit Latch).

Nach Abschluß des Einlesens wird der Mikroprozessor 10 durch seinen Bootstrap an- und in einer Überwachungsschleife bezüglich des Pegels auf seiner Datenleitung 13 gehalten. Ab diesem Zeitpunkt kann die Schnittstellenverbindung durch C aufgehoben bzw. können die Geräte A und B elektrisch voneinander getrennt werden.

Dieser Trennvorgang wird zum Auslösen des Abspeicherns der ins RAM des Mikroprozessors eingelesenen Daten in den nichtflüchtigen Speicherbaustein 11 ausgenutzt wie folgt.

Infolge der Trennung geht die Datenleitung 13 vermittels des in jedem Gerät vorhandenen Widerstands R₁₂ auf Pegel "L", da immer noch 10.1 = "H", d.h. der Speicherbausteinbaustein 11 am hier beispielhaften Port 11.3 nach wie vor hochohmig ist.

Der Mikroprozessor 10 erkennt diesen nach dem Abschluß des Einlesens noch auftretenden "H->L"-Übergang (Data-Excess-Flanke) auf seiner Datenleitung 13 und wertet ihn (sie)aus als Instruktion "Schreibe eingelesene Daten zurück in den nichtflüchtigen Speicherbaustein", setzt folglich seinen MEMSTAT-Port 10.1 auf "L" und seinen W/R-Ausgang 10.2 auf "H", aktiviert dadurch den Speicherbaustein 11 zum Einlesen der zuvor in sein RAM eingelesenen Daten, und gibt diese Daten über die Leitung 13 somit an den Datenport 11.3 des Speicherbausteins 11.3 aus. Nach Abschluß dieser Operation hat der Speicherbaustein 11 bereits denselben Dateninhalt wie der ausgelesene Speicherbaustein 21 und der Mikroprozessor setzt seinen W/R-Ausgang 10.2 wieder auf Pegel "L" (Lesen).

Optional kann im Boot-Programm des Mikroprozessors 10 vorgesehen sein, daß sich letzterer anschließend von selbst neu startet. Darüber hinaus kann optional vorgesehen sein, daß der Mikroprozessor 10 nach diesem Neustart die Applikation ganz normal aus dem Speicher 11 hochbootet. Dies ist ohne weiteres möglich deshalb, weil im Zeitpunkt des Neustarts das Gerät B ja gar nicht mehr vorhanden ist und insoweit die oben unter "Normalbetrieb" beschriebenen Verhältnisse vorliegen.

Ohne zusätzliche Mittel kann am bloßen Erreichen der normalen Betriebsbereitschaft des Gerätes A das Abgeschlossensein des Kopiervorganges und - je nach Beschaffenheit des Boot-Programmes des Mikroprozessors - ggfs. sogar die Fehlerlosigkeit der erfolgten Datenübertragung erkannt werden.

Das insoweit beschriebene Ausführungsbeispiel bedient sich ebenfalls einer synchronen Datenübertragung und kommt mit nur vier leitenden Verbindungen U+, U-/GND, T und D an der Schnittstelle aus. Auch hier ist eine Abwandlung für asynchronen Betrieb möglich, die alerdings etwas mehr Aufwand erfordert.

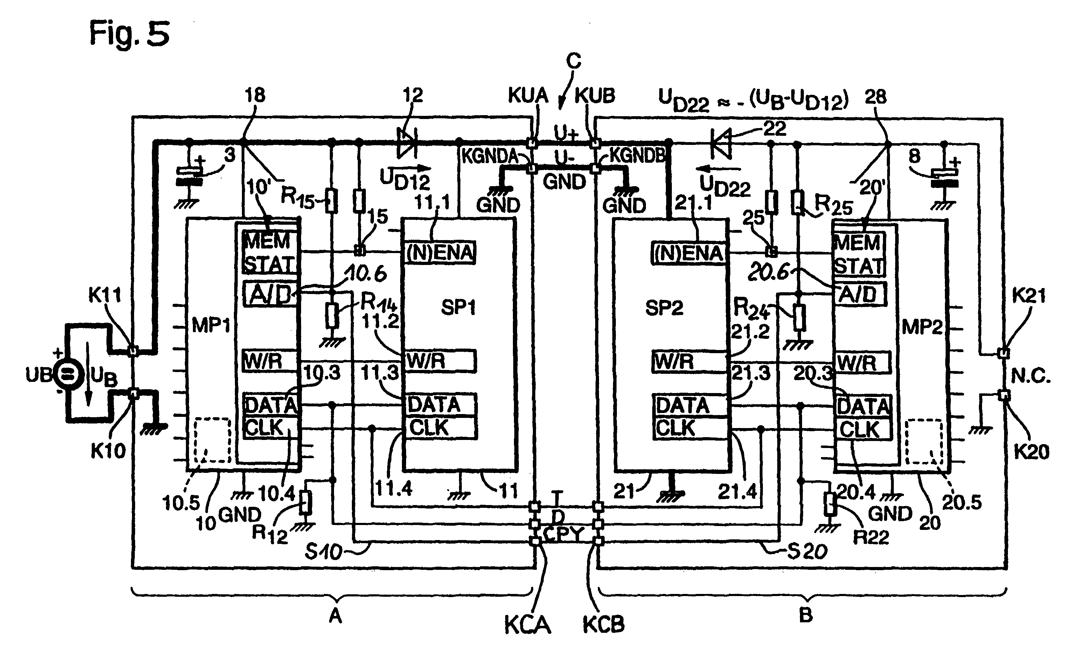

Eine Vereinfachung ergibt sich, wenn gemäß Fig. 5 ein fünfter Verbindungspfad CPY (für COPY) an der Schnittstelle vorgesehen und als Mikroprozessor z.B. ein solcher mit bereits integriertem A/D-Wandler (Microcontroller) verwendet wird. Dabei resultiert die Vereinfachung dann hauptsächlich daraus, daß bei der Programmierung des Bootstraps weniger beachtet werden muß.

In einem entsprechenden Gerät A bzw. B kann z.B. ein aus zwei in Serie geschalteten Widerständen R₁₄ und R₁₅ bestehender Spannungsteiler zwischen der Versorgungsschiene 18 bzw. 28 und jeweils GND liegend vorgesehen werden, dessen mittige Verbindung einerseits mit einem entsprechenden A/D-Eingang 10.6 bzw. 20.6 des betreffenden Microcontrollers 10 bzw. 20 im Gerät A bzw. B und andererseits über einen Pfad S10 bzw. S20 mit einem entsprechenden fünften Kontakt KCA bzw. KCB an der Schnittstelle verbunden ist.

Bei beispielsweise gleichen Ohmwerten der Widerstände R₁₄ und R₁₅ steht an besagtem Mittelabgriff im Gerät A bei fehlendem Gerät B die Spannung U_{R14} = ½U_{B} gegen Masse GND an, die in ein programmiertes erstes Wertefenster für ½U_{B} mit z.B. ±15% Toleranzweite fällt. Präsenz der Spannung U_{R14} in diesem Wertefenster wird vom Microcontroller 10 als Wahrheitsbedingung "B fehlt" interpretiert.

Unter denselben Bedingungen steht an besagtem Mittelabgriff bei an der Schnittstelle über die Pfade CPY und U-/GND miteinander vorhandenen Geräten A und B aufgrund der fehlenden Stromversorgung des Gerätes B die wesentlich geringere Spannung ¼U_{B} gegen Masse an, die in ein programmiertes zweites Wertefenster für ¼U_{B} mit z.B. ±15% Toleranzweite fällt. Dabei resultiert die Spannung ¼U_{B} deshalb, weil im unbestromten Gerät B die Versorgungsschiene 28 virtuell an Masse GND liegt, d.h. die Widerstände R₂₄ und R₂₅ parallel zum identischen Widerstand R₁₄ liegend in Erscheinung treten, woraus ein Teilverhltnis von (1/3)/(4/3) = ¼ folgt. Präsenz der Spannung U_{R14} im vorgenannten Wertefenster wird vom Microcontroller 10 als Wahrheitsbedingung "B vorhanden" interpretiert.

Im vorliegenden Fall kann der Microcontroller also seinen MEMSTAT-Port erst dann auf Pegel "L" setzen und dadurch den Speicherbaustein 11 aktivieren, wenn er die Wahrheitsbedingung im ersten Spannungsfenster gefunden hat, was aber erst nach dem Auftrennen des Schnittstellenpfades CPY überhaupt möglich ist. Die Überwachung des Datenpfades D nach dem Einlesen der Daten in den RAM-bereich des Microcontrollers 10 kann hier ebenso entfallen wie die Last-Bit-Latch-Fähigkeit der Speicherbausteine 11 und 21 in aktiviertem Zustand nach Taktpuls-Stop.

Sowohl dem zweiten als auch dritten Ausführungsbeispiel ist ersichtlich gemeinsam, daß an die Stelle einer Schalteinrichtung die Überwachung eines Signalpegels im Zielgerät des Datentransfers tritt, wobei dieser Pegel - spätestens nach dem Auslesen der Daten aus dem Quellenspeicher des Gerätes B - durch letzteres im Gerät A jedenfalls charakteristisch veränderbar ist unabhängig davon, ob das Gerät B defekt ist oder nicht.

Aus der insoweit beschriebenen Funktion des zweiten und dritten Ausführungsbeispiels nebst Abwandlungsmöglichkeiten entnimmt der Fachmann ein in der Anwendungspraxis äußerst vorteilhaftes **Verfahren** zur Duplizierung eines elektronischen Gerätes B mit Mikroprozessor und nichtflüchtigem Speicher in ein entsprechendes Gerät A wie folgt:

In einem **ersten Schritt** werden zwei stromlose (U_{B} = Null) Geräte A und B mittels ihrer Schnittstellen miteinander verbunden ("Zusammenstecken"), d.h. wenigstens KUA und KUB, KGNDA und KGNDB, KTA und KTB sowie KDA und KDB werden miteinander verbunden (U+, U-/GND, T, D). Dabei sind ihre normalen Versorgungsklemmen unbeaufschlagt.

Sollen Daten aus dem Gerät B in das Gerät A übertragen werden, wird in einem **zweiten Schritt** das Gerät A an seinen normalen Versorgungsklemmen mit seiner normalen Betriebsspannung beaufschlagt, nicht jedoch das Gerät B. Dessen Versorgungsklemmen bleiben vorzugsweise frei, könnten gleichwohl aber auch kurzgeschlossen werden.

In einem **dritten Schritt** wird der nichtflüchtige Speicherbaustein 11 des Gerätes A durch dessen Bestromung initial zunächst zwangsläufig deaktiviert und der nichtflüchtige Speicherbaustein 21 des Gerätes B sofort zwangsläufig aktiviert.

In einem **vierten Schritt** erkennt der Mikroprozessor des Gerätes A am sofortigen Aktiviertsein eines nichtflüchtigen Speicherbausteins, daß es sich dabei nicht um den eigenen noch inaktiv gehaltenen handelt und wird infolgedessen veranlaßt, im nichtflüchtigen Speicherbaustein des Gerätes B liegende Daten in seinen RAM-Bereich einzulesen.

In einem **fünften Schritt** wird (vom Bediener) abgewartet, bis der Mikroprozessor des Gerätes A nach dem Abschluß des Auslesevorganges zur Überwachung eines Signalpegels übergegangen ist, welcher Signalpegel (spätestens dann) über die Schnittstelle hinweg vom Gerät B im Gerät A in charakteristischer Weise zwangsläufig verursacht wird, um dadurch dem Mikroprozessor die Präsenz bzw. Nichtpräsenz des Gerätes B anzuzeigen.

In einem **sechsten Schritt** wird daraufhin - unter Aufrechterhaltung der Stromversorgung des Gerätes A - vom Bediener die elektrische Verbindung der beiden Geräte A und B über ihre Schnittstelle aufgehoben.

In einem **siebten Schritt** wird diese elektrische Trennung aufgrund der vorgenannten Pegelüberwachung sensiert und vom Mikroprozessor des Gerätes A als Wahrheitsbedingung ausgewertet als Wahrheitsbedingung ausgewertet für das nun mögliche Zurückschreiben der zuvor von ihm in seinen RAM-Bereich eingelesenen Daten in den einzigen noch vorhandenen nichtflüchtigen Speicherbaustein, nämlich den des Gerätes A.

In einem **achten Schritt** wird das Einschreiben der Daten in den vorgenannten nichtflüchtigen Speicherbaustein initiiert, durchgeführt und vom Bediener abgewartet, bis dieser Einschreibvorgang beendet ist.

Optional kann noch in einem **neunten Schritt** abgewartet werden, bis sich der Mikroprozessor neu gestartet hat und/oder bis der Mikroprozessor die Applikation des Gerätes A ganz normal hochgebootet und das Gerät normale Betriebsbereitschaft erreicht hat.

Im Zuge dieses Verfahrens wird der Datentransfer überaus einfach durch eine sehr einfache und nur sehr wenige Programmschritte beanspruchende Erweiterung des Bootstraps des Mikroprozessors (erweitert um zustandsabhängige Portabfragen) gesteuert.

Dabei kann wenigstens ein Teil des Bootstraps des Mikroprozessors im nichtflüchtigen Speicherbaustein abgelegt sein, mit der Folge, daß dieser Teil jeweils 1:1 in den neuen nichtflüchtigen Speicherbaustein mitübertragen wird, somit nie verloren gehen und für eine automatische Richtigkeitsprüfung der erfolgten Datenübertragung herangezogen werden kann.

In diesem Falle kann gleichwohl wenigstens ein (anderer) Teil des Bootstraps in einem besonderen ROM-Bereich (10.5 bzw. 20.5) des Mikroprozessors abgelegt sein, welcher integraler Bestandteil des Mikroprozessors sein kann.

Insoweit kann also verfahrensgemäß in einem **zehnten Schritt** beim obengenannten Hochbootvorgang der Applikation auch noch die Richtigkeit der stattgefundenen Datenübertragung geprüft werden.

Schließlich kann noch in einem **elften Schritt** aus der erreichten Betriebsbereitschaft des Gerätes A des Abgeschlossenseins und/oder die Richtigkeit der erfolgten Datenübertragung aus dem nichtflüchtigen Speicher 21 des Gerätes B in den nichtflüchtigen Speicher 11 des Gerätes A erkannt werden.

Alles in allem übernimmt insoweit ein neues Gerät A die nichtflüchtig abgespeicherten Daten eines alten Geräts B, bzw. letzteres "vererbt" seine Daten zwangsläufig an das neue Gerät A weiter. Im Hinblick auf ein Verkehrsmittel ist es so beispielsweise gewährleistet, daß das neue Gerät A bezüglich gespeicherter Fahrzeugparameter und Lebenslaufdaten auf absolut demselben Stand ist wie das alte Gerät B. Es kann somit ein nahtloser Weiterbetrieb mit aufgelaufenen Parametern erfolgen unter Ausschluß jeglilichen Sorgfaltsaufwands in Wiederanlwernphasen. Ersatzlogistik entfällt komplett.

Das erfindungsgemäße **elektronische Gerät** und die erfindungsgemäße **Verfahren**sweise können vorteilhaft auch dazu genutzt werden, um auf einfache Art und Weise Geräte in beliebiger Zahl identisch herzustellen. Auch besteht z. B. die Möglichkeit, an einem Fertigungsband vormals jungfräuliche Geräte - oder aber zuvor für einen anderen Zweck bereits programmierte Geräte - auf einen neuen Applikationszweck, etwa ein aktuelles Ausstattungs- oder Fahrzeugmodell oder einen Serienwechsel "einzustellen".

### Bezugszeichenliste

Elektronisches Gerät, Verfahren zu seiner Duplizierung und Einrichtung zur Datenübertragung zwischen zwei gleichartig aufgebauten elektronischen Geräten
- A: erstes Gerät
- B: zweites Gerät
- D: Datenpfad- bzw. leitung
- DI: Diode
- I: Schnittstelle
- MP, MP1, MP2: Mikroprozessor, Microcontroller
- S: steuerbare Schalteinrichtung
- S1: erste Schaltmittel
- S2: zweite Schaltmittel
- SP, SP1, SP2: nichtflüchtiger Speicher
- T: Taktsignalpfad bzw. -leitung
- UB: Betriebsspannungsquelle
- U+, U-: Betriebsspannung (extern zugeführt)
- Z1: Zugriffssteuerleitung (auf erste Schaltmitel)
- Z2: Zugriffssteuerleitung (auf zweite Schaltmittel)
- Z10, Z20: Widerstand, Stromquelle

- 10, 20: Mikroprozessor, Microcontroller
- 11, 21: nichtflüchtiger Speicherbaustein
- 12, 22: Diode (Versorgungsventil)
- 13, 23: Datenleitung im Gerät A bzw, B
- 14, 24: Taktleitung im Gerät A bzw. B
- 15, 25: Verbindungspunkt
- 16, 26: Ventil, z.B. Diode
- 17, 27: Speicherstatuspfad
- 18, 28: Versorgungsschiene
- 19, 29: Schreib-/Lesesteuerleitung im Gerät A bzw. B
- 3, 8: Energiespeicher im Gerät A bzw. B

- KUA, KUB: Schnittstellenkontakt **U+** im Gerät A bzw. B
- KGNDA, KGNDB: Schnittstellenkontakt **U-/GND** im Gerät A bzw. B
- KTA, KTB: Schnittstellenkontakt **Takt** im Gerät A bzw. B
- KDA, KDB: Schnittstellenkontakt **Daten** im Gerät A bzw. B
- KCA, KCB: Schnittstellenkontakt **COPY** im Gerät A bzw. B
- U_{B}: Versorgungsspannung

Zusammenfassende Bezeichnungen
- MP, MP1, MP2, SP, SP1, SP2, I: Bausteine
- D, T: Signalleitungen
- U+, U-, U-/GND, D, T, CPY: Schnittstellenpfade bzw. - leitungen
- C: Schnittstellenpfadrealisierung (materialisiert oder nichtmaterialisiert)
- KUA, KGNDA, KTA, KDA (, KCA): Schnittstelle
- KUB, KGNDB, KTB, KDB (, KCB): Schnittstelle
- N.C.: Bedeutung "ohne Anschluß"

## Patentansprüche

1. Elektronisches Gerät, nachfolgend erstes elektronisches Gerät genannt, mit einem Mikroprozessor oderMicrocontroller(MP; MP1, 10),einem nichtflüchtigen Speicher (SP; SP1)undeinerSchnittstelle (I; KUA, KGNDA, KTA, KDA, KCA),
**dadurch gekennzeichnet,**
**daß** die Schnittstelle (I; KUA, KGNDA, KTA, KDA; KCA) so beschaffen ist, daß diese mit einer entsprechenden Schnittstelle (I; KUB, KGNDB, KTB, KDB; KCB) eines gleichartig aufgebauten zweiten elektronischen Gerätes (B) verbindbar (C) ist und daß das Gerät (A) so beschaffen ist, daß nur sein nichtflüchtiger Speicher (SP1) von der Schnittstelle (I; **KUA**, **KGNDA**, KTA, KDA, KCA) aus mit einer Betriebsspannung (U+/U-) versorgbar ist und daß bei Verbindung (C) der Schnittstellen (I; KUA, KGNDA, KTA, KDA; KCA; KUB, KGNDB, KTB, KDB; KCB) des ersten und des zweiten elektronischen Gerätes (A, B) miteinander und bei am ersten Gerät (A) anliegender (K10, K11) Betriebsspannungsversorgung (UB) bzw. Betriebsspannung (U+/U-; U_{B}) des ersten Gerätes (A) der Inhalt des nichtflüchtigen Speichers (SP; SP2) des zweiten Gerätes (B) in den nichtflüchtigen Speicher (SP; SP1) des ersten Gerätes (A) zwangsläufig kopierbar ist.

2. Elektronisches Gerät nach Anspruch 1,
**dadurch gekennzeichnet,**
**daß** es im übrigen so beschaffen ist, daß bei wahlweiser Betriebsspannungsversorgung des zweiten Gerätes (B) der Inhalt des nichtflüchtigen Speichers (SP; SP1) des ersten Gerätes (A) in den nichtflüchtigen Speicher (SP, SP2) des zweiten Gerätes (B) zwangsläufig kopierbar ist.

3. Elektronisches Gerät, mit einem Mikroprozessor (MP), einem nichtflüchtigen Speicher (SP) und einer Schnittstelle (I) nach Anspruch 1, wobei von jedem dieser Bausteine (MP, SP, I) mindestens eine Signalleitung (D, T) ausgeht, und einer steuerbaren Schalteinrichtung (S), die mit den Signalleitungen (D, T) der Bausteine (MP, SP, I) verbunden ist,
**dadurch gekennzeichnet,**
**daß** die steuerbare Schalteinrichtung (S) mehrere mögliche Schaltzustände aufweist, in denen die mindestens eine Signalleitung (D, T) von jeweils mindestend zwei der drei Bausteine (MP, SP, I) miteinander verbunden sind, und daß die steuerbare Schalteinrichtung (S) über die Schnittstelle (I) in einen Schaltzustand gesteuert werden kann, in welchem die Schalteinrichtung (S) die mindestens eine Signalleitung (D, T) des nichtflüchtigen Speichers (SP) mit der Schnittstelle (1) verbindet.

4. Elektronisches Gerät nach Anspruch 3,
**dadurch gekennzeichnet,**
**daß** ein an der Schnittstelle (I) anliegendes logisches Signal die Schalteinrichrtung (S) in den Schaltzustand steuert, in welchem sie die mindestens eine Signalleitung (D, T) des nichtflüchtigen Speichers (SP) mit der mindestens einen Signalleitung (D, T) der Schnittstelle (1) verbindet.

5. Elektronisches Gerät nach Anspruch 3,
**dadurch gekennzeichnet,**
**daß** die an der Schnittstelle (I) anliegende Betriebsspannung (U+, U-) eines weiteren gleichartig aufgebauten elektronischen Gerätes (A), die Schalteinrichtung (S) in den Schaltzustand steuert, in welchem sie die zumindest eine Signalleitung (D, T) des nichtflüchtigen Speichers (SP) mit der mindestens einen Signalleitung (D, T) der Schnittstelle (I) verbindet.

6. Elektronisches Gerät nach Anspruch 3,
**dadurch gekennzeichnet,**
**daß** jeder Baustein (MP, SP, I) als Signalleitungen genau eine serielle Datenleitung (D) und eine Taktsignalleitung (T) aufweist.

7. Elektronisches Gerät nach Anspruch 3,
**dadurch gekennzeichnet,**
**daß** die Schalteinrichtung erste Schaltmittel (S1) zum Umschalten der Verbindung der mindestens einen Signalleitung (D, T) zwischen Mikroprozessor (MP) und dem nichtflüchtigen Speicher (SP) einerseits und zwischen dem Mikroprozessor (MP) und der Schnittstelle (I) andererseits aufweist und daß diese ersten Schaltmittel (S1) über eine Leitung zur Zugriffssteuerung (Z1) durch den Mikroprozessor (MP) gesteuert werden.

8. Elektronisches Gerät nach Anspruch 7,
**dadurch gekennzeichnet,**
**daß** der Schaltzustand der ersten Schaltmittel (S1) bei nicht mit Spannung beaufschlagtem Mikroprozessor (MP) die Verbindung der mindestens einen Signalleitung (D, T) zwischen der Schnittstelle (I) und dem nichtflüchtigen Speicher (SP) ermöglicht.

9. Elektronisches Gerät nach Anspruch 3,
**dadurch gekennzeichnet,**
**daß** die Schalteinrichtung(S) zweite Schaltmittel (S2) aufweist, die ein Umschalten der Verbindung zwischen der Schnittstelle (I) und dem Mikroprozessor (MP) einerseits und zwischen Schnittstelle (I) und dem nichtflüchtigen Speicher (SP) andererseits ermöglicht.

10. Elektronisches Gerät nach Anspruch 9,
**dadurch gekennzeichnet,**
**daß** der Schaltzustand der zweiten Schaltmittel (S2) vom Anliegen eines Spannungssignales, von einer internen Betriebsspannungsquelle (UB) und/oder von Spannungssignalen an der Schnittstelle (I) an einer zweiten Leitung zur Zugriffssteuerung (Z2) der Schalteinrichtung (S) abhängt.

11. Elektronisches Gerät nach Anspruch 3,
**dadurch gekennzeichnet,**
**daß** die Schnittstelle (I) eine Schutzschaltung und/oder Treiberschaltung aufweist, über die die mindestens eine Signalleitung (D, T) zu einem Außenanschluß des Gerätes geführt ist.

12. Elektronisches Gerät nach Anspruch 3,
**dadurch gekennzeichnet,**
**daß** über die Schnittstelle (I) zumindest der nichtflüchtige Speicher (SP) und die Schalteinrichtung (S) durch eine externe Betriebsspannnung (U+, U-) versorgt werden können.

13. Elektronisches Gerät nach Anspruch 1,
**dadurch gekennzeichnet,**
**daß** die Schnittstelle durch Kontakte (KUA, KGNDA, KTA, KDA, KCA bzw. KUB, KGNDB, KTB, KDB, KCB) umfaßt und das Gerät im übrigen so beschaffen ist, daß es mit einem weiteren, identischen Gerät ohne materialisierte Verbindungsmittel wie Kabel (C), Adaper etc. unmittelbar zusammensteckbar ist.

14. Elektronisches Gerät nach Anspruch 1,
**dadurch gekennzeichnet,**
**daß** alle Hardwaremittel (12, Z10, R₁₁, R₁₂, R₁₄, R₁₅), welche das Merkmal der zwangsläufigen Kopierbarkeit konstituieren, nur einfache elektrische Bauelemente mit jeweils nur zwei Betriebsanschlüssen sind.

15. Elektronisches Gerät nach Anspruch 1,
**dadurch gekennzeichnet,**
**daß** es eine Versorgungsschiene (18) aufweist, aus der der Mikroprozessor bzw. Microcontroller (10) mit Strom versorgt wird und daß diese Versorgungsschiene (18) durch einen Energiespeicher (3) gestützt ist.

16. Elektronisches Gerät nach Anspruch 1,
**dadurch gekennzeichnet,**
**daß** im Pfad zwischen dem Stromversorgungsanschluß des Mikroprozessors oder Microcontrollers (10) und dem Stromversorgungsanschluß des nichtflüchtigen Speicherbausteins eine Ventilstrecke (12) liegt.

17. Elektronisches Gerät nach Anspruch 1,
**dadurch gekennzeichnet,**
**daß** der nichtflüchtige Speicher (11) einen ENABLEoder NOT_ENABLE/INHIBIT-Eingang (11.1) aufweist, dessen Status vom Mikroprozessor bzw. Microcontroller sowohl abfragbar als auch setzbar ist.

18. Elektronisches Gerät nach Anspruch 17,
**dadurch gekennzeichnet,**
**daß** der Wirkungspfad (17) zur Abfrage und zum Setzen des ENABLE- oder NOT_ENABLE/INHIBIT-Eingangs (11.1) durch einen Widerstand (Z10) oder eine Stromquelle (Z10) mit dem Versorgungsspannungsanschluß des Mikroprozessors oder Microcontrollers (10) verbunden ist.

19. Elektronisches Gerät nach Anspruch 1,
**dadurch gekennzeichnet,**
**daß** die Datenleitung (13) zwischen dem Mikroprozessor oder Microcontroller (10) und dem nichtflüchtigen Speicher über einen Abschlußwiderstand (R₁₂) mit einem Bezugspotential (GND) verbunden ist.

20. Elektronisches Gerät nach Anspruch 16,
**dadurch gekennzeichnet,**
**daß** wenigstens ein Teil des Boot-Programmes des Mikroprozessors oder Microcontrollers (10) in dem von der Schnittstelle **(KUA, KGNDA,** KTA, KDA; KCA) aus stromversorgbaren nichtflüchtigen Speicherbaustein (11) abgelegt ist.

21. Elektronisches Gerät nach Anspruch 1,
**dadurch gekennzeichnet,**
**daß** die Schnittstelle außer Kontakten (KUA, KGNDA, KTA, KDA; KCA) mit diesen kooperative Mittel umfaßt, welche einen unbeabsichtigten oder unbefugten Zugang zu letzteren unmöglich machen.

22. Elektronisches Gerät nach Anspruch 21,
**dadurch gekennzeichnet,**
**daß** das Gerät (A) ein Gehäuse aufweist, welches einerseits in Bezug auf seine Schnittstelle (KUA, KGNDA, KTA, KDA; KCA) - und vice versa - und andererseits in Bezug auf ein zweites identisches Gerät (B) und dessen Schnittstelle (KUB, KGNDB, KTB, KDB; KCB) - und vice versa - so ausgebildet ist, daß die beiden Schnittstellen nur und nur durch Zusammenstecken der beiden Geräte (A und B) zu einer einzigen einkörperlich-funktionalen Einrichtung zur Datenübertragung miteinander verbindbar sind.

23. Verfahren zur Duplizierung eines ersten elektronischen Gerätes (B), welches einen Mikroprozessor (MP2), einen nichtflüchtigen Speicher (SP2) und eine Schnittstelle (KUB, KGNDB, KTB, KDB; KCB) aufweist, wobei die Schnittstelle (KUB, KGNDB, KTB, KDB; KCB) so beschaffen ist, daß diese mit einer entsprechenden Schnittstelle (KUA, KGNDA, KTA, KDA; möglicherweise auch KCA) eines zweiten, bezüglich Mikroprozessor und nichtflüchtigem Speicher gleichartig aufgebauten (MP1, SP1) elektronischen Gerätes (A) verbindbar (C) ist,
**gekennzeichnet durch folgende Schritte:**
(1) Verbinden (C) des ersten Gerätes (B) an seiner Schnittstelle (KUB, KGNDB, KTB, KDB; KCB) mit dem zweiten Gerät (A) an dessen Schnittstelle (KUA, KGNDA, KTA, KDA; KCA):
(2) Beaufschlagung der Versorgungsklemmen (K10, K11) des zweiten Gerätes (A) mit dessen normaler Betriebsspannung;
(3) Initiale Deaktivierung **durch** vorgenannte Beaufschlagung des nichtflüchtigen Speicherbausteins (11) im zweiten Gerät (A) und sofortige Aktivierung **durch** vorgenannte Beaufschlagung des nichtflüchtigen Speicherbausteins (21) im ersten Gerät (B);
(4) Erfassung seitens des Mikroprozessors (10) im zweiten Gerät (A), daß trotz Deaktivierung des Speicherbausteins (11) im zweiten Gerät (A) ein nichtflüchtiger Speicherbaustein (21) ansprechbar ist, und Initiierung und Durchführung des Einlesens von Daten aus dem nichtflüchtigen Speicher (21) im ersten Gerät (B) in einen Arbeitsspeicherbereich (10.5) des Mikroprozessors (10) im zweiten Gerät (A);
(5) Überwachen, nach dem Abschluß des Einlesens, eines Signalpegels (DATA; U_{R14}), der über die Schnittstelle (KUB, KGNDB, KTB, KDB; KCB / KUA, KGNDA, KTA, KDA; KCA) hinweg vom ersten Gerät (B) im zweiten Gerät (A) in charakteristischer Weise zwangsläufig verursacht wird, um **dadurch** dem Mikroprozessor (10) im zweiten Gerät (A) die Verbindungspräsenz zum ersten Gerät (B) anzuzeigen;
(6) Trennen, - unter Aufrechterhaltung der Stromversorgung des zweiten Gerätes (A) - der Schnittstelle (KUB, KGNDB, KTB, KDB; KCB / KUA, KGNDA, KTA, KDA; KCA) zwischen beiden Geräten (A und B);
(7) Erkennen, vermittels der Pegelüberwachung in Schritt (5), der Trennung der Schnittstelle (KUB, KGNDB, KTB, KDB; KCB / KUA, KGNDA, KTA, KDA; KCA) als Wahrheitsbedingung für ein nun mögliches Zurückschreiben der zuvor in besagten Arbeitsspeicherbereich (10.5) des Mikroprozessors (10) im zweiten Gerät (A) eingelesenen Daten in den nichtflüchtigen Speicherbaustein (11) des zweiten Gerätes (A);
(8) Initiierung und Durchführung des Zurückschreibens besagter Daten aus besagtem Arbeitsspeicherbereich (10.5) in den nichtflüchtigen Speicherbaustein (11) im zweiten Gerät (A) und Abwarten, bis dieser Vorgang beendet ist.

24. Verfahren nach Anspruch 23,
**gekennzeichnet durch** den weiteren Schritt
(9) Abwarten, bis der Mikroprozessor (10) sich neu gestartet hat und/oder bis der Mikroprozessor (10) die Applikation des zweiten Gerätes (A) normal hochgebootet und das Gerät (A) insoweit Betriebsbereitschaft erreicht hat.

25. Verfahren nach Anspruch 24,
**gekennzeichnet durch** den weiteren Schritt
(10) Prüfen im Verlaufe des Hochbootens, auf der Basis eines aus dem nichtflüchtigen Speicher (21) des ersten Gerätes (B) in den nichtflüchtigen Speicher (11) des zweiten Gerätes (A) mitübertragenen Elements des Bootprogrammes des Mikroprozessors (10) der Richtigkeit der erfolgten Datenübertragung.

26. Verfahren nach Anspruch 24 oder 25,
**gekennzeichnet durch** den weiteren Schritt
(11) Erkennen, aus der erreichten Betriebsbereitschaft des zweiten Gerätes (A), des Abgeschlossenseins und oder der Richtigkeit der erfolgten Datenübertragung aus dem nichtflüchtigen Speicher (21) des ersten Gerätes (B) in den nichtflüchtigen Speicher (11) des zweiten Gerätes (A).

27. Verwendung des Verfahrens gemäß Anspruch 23 bei bzw. zur Herstellung von elektronischen Geräten.

28. Einrichtung mit zwei gleichartig aufgebauten elektronischen Geräten nach Anspruch 3, wobei eine Datenübertragung zwischen diesen Geräten vorgesehen ist, **dadurch gekennzeichnet, dass** die Schnittstellen (I) des ersten (A) und des zweiten elektronischen Gerätes (B) verbindbar sind, wobei das erste Gerät (A) mit einer Betriebsspannungsquelle (UB) verbunden ist und das zweite elektronische Gerät (B) über die Schnittstelle (I) mit einer von der Betriebsspannung des ersten Gerätes (A) abgeleiteten Betriebsspannung (U+, U-) versorgt wird und dass durch die Verbindung der beiden Geräte (A, B) die Schalteinrichtungen (S) beider Geräte (A, B) in jeweils einen solchen Schaltzustand gebracht sind, dass eine durch den Mikroprozessor (MP) des ersten Gerätes (A) gesteuerte Datenübertragung aus dem nichtflüchtigen Speicher (SP) des zweiten Gerätes (B) zum nichtflüchtigen Speicher (SP) des ersten Gerätes (A) erfolgt.

29. Einrichtung mit zwei gleichartig aufgebauten elektronischen Geräten nach Anspruch 14, wobei eine Datenübertragung zwischen diesen Geräten vorgesehen ist, **dadurch gekennzeichnet, dass** der Mikroprozessor (MP) während der Schreibzeit eines Datenblocks im zu beschreibenden nichtflüchtigen Speicher (SP) bereits den nächsten zu übertragenden Datenblock aus dem zu lesenden nichtflüchtigen Speicher (SP) ausliest.

## Claims

1. An electronic device, hereinafter called a first electronic device, comprising a microprocessor or microcontroller (MP; MP1, 10), a nonvolatile memory (SP; SP1) and an interface (I; KUA, KGNDA, KTA, KDA, KCA),
**characterised in that**
the interface (I, KUA, KGNDA, KTA, KDA) is designed so that it can be connected (C) to a corresponding interface (I; KUB, KGNDB, KTB, KDB) of a second electronic device (B) of the same type of construction, and that the device (A) is designed so that only its nonvolatile memory (SP1) can be supplied with an operating voltage (U+/U-) from the interface (I; KUA, KGNDA, KTA, KDA) and that when the interfaces (I; KUA, KGNDA, KTA, KDA; KUB, KGNDB, KTB, KDB) of the first and second electronic devices (A, B) are connected (C) to each other and when an operating voltage supply (UB) or operating voltage (U+/U-; UB) of the first device (A) is applied (K10, K11) to the first device (A) the content of the nonvolatile memory (SP; SP2) of the second device (B) can be forcibly copied to the nonvolatile memory (SP; SP1) of the first device (A).

2. An electronic device according to claim 1,
**characterised in that**
it is designed in addition so that when the second device (B) is optionally supplied with its operating voltage the content of the nonvolatile memory (SP; SP1) of the first device (A) can be forcibly copied to the nonvolatile memory (SP, SP2) of the second device (B).

3. An electronic device comprising a microprocessor (MP), a nonvolatile memory (SP) and an interface (I) according to claim 1, wherein at least one signal line (D, T) and a controllable switching device (S) which is connected to the signal lines (D, T) of the components (MP, SP, I) originate from each of these components (MP, SP, I),
**characterised in that**
the controllable switching device (S) comprises a plurality of possible switching states in which the at least one signal line (D, T) of at least two of the three components (MP, SP, I) are connected to each other, and that the controllable switching device (S) can be directed via the interface (I) into a switching state in which the switching device (S) connects the at least one signal line (D, T) of the nonvolatile memory (SP) to the interface (I).

4. An electronic device according to claim 3,
**characterised in that**
a logic signal which is present at the interface (I) directs the switching device (S) into the switching state in which the switching device (S) connects the at least one signal line (D, T) of the nonvolatile memory (SP) to the at least one signal line (D, T) of the interface (I).

5. An electronic device according to claim 3,
**characterised in that**
the presence at the interface (I) of the operating voltage (U+, U-) of a further electronic device (A) of the same type of construction directs the switching device (S) into the switching state in which it connects the at least one signal line (D, T) of the nonvolatile memory (SP) to the at least one signal line (D, T) of the interface (I).

6. An electronic device according to claim 3,
**characterised in that**
each component (MP, SP, I) specifically comprises a serial data line (D) and a timing signal line (T) as signal lines.

7. An electronic device according to claim 3,
**characterised in that**
the switching device comprises first switching means (S1) for switching over the connection of the at least one signal line (D, T) from a connection between the microprocessor (MP) and the nonvolatile memory (SP) to a connection between the microprocessor (MP) and the interface (I) and that said first switching means (S1) are controlled by the microprocessor (MP) via a line for access control (Z1).

8. An electronic device according to claim 7,
**characterised in that**
when the microprocessor (MP) is not acted upon by a voltage the switching state of the first switching means (S1) enables the at least one signal line (D, T) to be connected between the interface (I) and the nonvolatile memory (SP).

9. An electronic device according to claim 3,
**characterised in that**
the switching device (S) comprises second switching means (S2) which enable a changeover to be made from a connection between the interface (I) and the microprocessor (MP) to a connection between the interface (I) and the nonvolatile memory (SP).

10. An electronic device according to claim 9,
**characterised in that**
the switching state of the second switching means (S2) depends on the presence, at a second line for the access control (Z2) of the switching device (S), of a voltage signal, of an internal source of operating voltage (UB) and/or of voltage signals at the interface (I).

11. An electronic device according to claim 3,
**characterised in that**
the interface (I) comprises a protective circuit and/or a driver circuit via which the at least one signal line (D, T) is led to an external connection of the device.

12. An electronic device according to claim 3,
**characterised in that**
at least the nonvolatile memory (SP) and the switching device (S) can be supplied via the interface (I) with an external operating voltage (U+, U-).

13. An electronic device according to claim 1,
**characterised in that**
the interface comprises contacts (KUA, KGNDA, KTA, KDA, KCA; KUB, KGNDB, KTB, KDB, KCB), and the device is also designed so that it can be plugged directly into a further, identical device without physical connection means such as cables (C), adapters, etc.

14. An electronic device according to claim 1,
**characterised in that**
all the hardware means (12, Z10, R11, R12, R14, R15) which constitute the feature of the capacity for being forcibly copied are merely simple electrical components which each comprise only two operating connections.

15. An electronic device according to claim 1,
**characterised in that**
it comprises a supply bus (18) from which the microprocessor or microcontroller (10) is supplied with power and that said supply bus (18) is backed up by an energy storage device (3).

16. An electronic device according to claim 1,
**characterised in that**
a valve section (12) is situated in the path between the power supply connection to the microprocessor or microcontroller (10) and the power supply connection to the nonvolatile memory component.

17. An electronic device according to claim 1,
**characterised in that**
the nonvolatile memory (11) comprises an ENABLE or NOT_ENABLE/INHIBIT input (11.1), the status of which can be both interrogated and set by the microprocessor or microcontroller.

18. An electronic device according to claim 17,
**characterised in that**
the effective path (17) for interrogating and setting the ENABLE or NOT_ENABLE/INHIBIT input (11.1) is connected by a resistor (Z10) or a current source (Z10) to the supply voltage connection of the microprocessor or microcontroller (10).

19. An electronic device according to claim 1,
**characterised in that**
the data line (13) between the microprocessor or microcontroller (10) and the nonvolatile memory is connected to a reference potential (GND) via a terminal resistor (R12).

20. An electronic device according to claim 16,
**characterised in that**
at least part of the boot program of the microprocessor or microcontroller (10) is stored in the nonvolatile memory component (11) which can be supplied with power from the interface (KUA, KGNDA, KTA, KDA; KCA).

21. An electronic device according to claim 1,
**characterised in that**
in addition to contacts (KUA, KGNDA, KTA, KDA; KCA) the interface comprises means which cooperate therewith and which make it impossible to obtain unintentional or unauthorised access thereto.

22. An electronic device according to claim 21,
**characterised in that**
the device (A) comprises a housing which is constructed firstly with respect to its interface (KUA, KGNDA, KTA, KDA; KCA) - and vice versa - and secondly with respect to a second identical device (B) and the interface (KUB, KGNDB, KTB, KDB; KCB) thereof - and vice versa - so that the two interfaces can only be connected to each other for data transfer and only by plugging the two devices (A and B) into each other to form a single arrangement which functions as unitary body.

23. A method of duplicating a first electronic device (B), which comprises a microprocessor (MP2), a nonvolatile memory (SP2) and an interface (KUB, KGNDB, KTB, KDB; KCB), wherein the interface (KUB, KGNDB, KTB, KDB; KCB) is designed so that it can be connected to a corresponding interface (KUA, KGNDA, KTA, KDA; possibly KCA also) of a second electronic device (A) which is of the same type of construction with respect to its microprocessor and nonvolatile memory (MP1, SP1),
**characterised by the following steps:**
(1) connection (C) of the first device (B) at its interface (KUB, KGNDB, KTB, KDB; KCB) to the second device (A) at the interface (KUA, KGNDA, KTA, KDA; KCA) thereof;
(2) application of the normal operating voltage of the second device (A) to the supply terminals (K10, K11) thereof;
(3) initial deactivation by the aforementioned action upon the nonvolatile memory component (11) in the second device (A) and immediate activation by the aforementioned action upon the nonvolatile memory component (21) in the first device (B);
(4) determination by the microprocessor (10) in the second device (A) that despite the deactivation of the memory component (11) in the second device (A) a nonvolatile memory component (21) can be addressed, and initiating and effecting the reading of data from the nonvolatile memory (21) in the first device (B) into a working memory region (10.5) of the microprocessor (10) in the second device (A);
(5) after reading-in is complete, monitoring a signal level (DATA; UR14) which is forcibly generated in a characteristic manner in the second device (A) from the first device (B) via the interface (KUB, KGNDB, KTB, KDB; KCB / KUA, KGNDA, KTA, KDA; KCA) in order thereby to indicate, to the microprocessor (10), the presence in the second device (A) of a connection to the first device (B);
(6) whilst maintaining the power supply to the second device (A), separating the interfaces (KUB, KGNDB, KTB, KDB; KCB / KUA, KGNDA, KTA, KDA; KCA) between the two devices (A and B);
(7) identifying, by means of monitoring the level in step (5), the separation of the interfaces (KUB, KGNDB, KTB, KDB; KCB / KUA, KGNDA, KTA, KDA; KCA) as a truth condition for the writing, which is now possible, of the data previously read to said working memory region (10.5) of the microprocessor
(10) in the second device (A) to the nonvolatile memory component (11) of the second device (A);
(8) initiating and effecting the writing of said data from said working memory region (10.5) to the nonvolatile memory component (11) in the second device (A) and waiting until this operation is complete.

24. A method according to claim 23,
**characterised by the further step of**
(9) waiting until the microprocessor (10) has been re-started and/or until the microprocessor (10) has booted up the application of the second device (A) normally and the device (A) has reached a state of readiness to operate in this respect.

25. A method according to claim 24,
**characterised by the further step of**
(10) checking, in the course of booting up, the correctness of the data transfer effected based on an element of the boot program of the microprocessor (10) which is transferred in conjunction from the nonvolatile memory (21) of the first device (B) to the nonvolatile memory (11) of the second device (A).

26. A method according to claim 24 or 25,
**characterised by** the further step of
(11) identifying the completion and/or the correctness of the data transfer which has been effected from the nonvolatile memory (21) of the first device (B) to the nonvolatile memory (11) of the second device (A) from the state of readiness to operate which has been reached by the second device (A).

27. Use of the method according to claim 23 in or for the production of electronic devices.

28. An arrangement comprising two electronic devices of the same type of construction according to claim 3, wherein data transfer is provided between said devices, **characterised in that** the interfaces (I) of the first (A) and of the second electronic device (B) can be connected, wherein the first device (A) is connected to a source of operating voltage (UB) and the second electronic device (B) is supplied, via the interface (I), with an operating voltage (U+, U-) which is derived from the operating voltage of the first device (A), and that by connecting the two devices (A, B) the switching devices (S) of both devices (A, B) are each brought into a switching state such that a transfer of data, which is controlled by the microprocessor (MP) of the first device (A), is effected from the nonvolatile memory (SP) of the second device (B) to the nonvolatile memory (SP) of the first device (A).

29. An arrangement comprising two electronic devices of the same type of construction according to claim 14, wherein data transfer is provided between said devices, **characterised in that** during the time of writing of a data block to the nonvolatile memory (SP) to be written to, the microprocessor (MP) is already reading out the next data block to be transferred from the nonvolatile memory (SP) to be read.

## Revendications

1. Appareil électronique, désigné ci-après comme étant le premier appareil électronique, comportant un microprocesseur ou un microcontrôleur (MP; MP1, 10), une mémoire non volatile (SP; SP1) et une interface (I; KUA, KGNDA, KTA, KDA, KCA),
**caractérisé en ce**
**que** l'interface (I; KUA, KGNDA, KTA, KDA; KCA) est agencée de telle sorte que cette interface peut être reliée à une interface correspondante (I; KUB, KGNDB, KTB, KDB; KCB) d'un second appareil électronique (B) agencé de la même manière, et que l'appareil (A) est agencé de telle sorte que seule sa mémoire non volatile (SP1) peut être alimentée avec une tension de fonctionnement (U+/U-) à partir de l'interface (I; KUA, KGNDA, KTA, KDA, KCA) et que dans le cas de la liaison (C) réciproque entre les interfaces (I; KUA, KGNDA, KTA, KDA; KCA; KUB, KGNDB, KTB, KDB; KCB) du premier et du second appareils électroniques (A, B) et dans le cas de l'alimentation en tension de fonctionnement (UB) ou de la tension de fonctionnement (U+/U-; U_{B}) du premier appareil (A), appliquée (K10, K11) au premier appareil (A), le contenu de la mémoire non volatile (SP; SP2) du second appareil (B) peut être copiée de façon forcée dans la mémoire non volatile (SP; SP1) du premier appareil (A).

2. Appareil électronique selon la revendication 1, **caractérisé en ce qu'**il est agencé par ailleurs de telle sorte que dans le cas de l'alimentation de tension de fonctionnement, réalisée au choix, du second appareil (B) le contenu de la mémoire non volatile (SP; SP1) du premier appareil (A) peut être copiée de façon forcée dans la mémoire non volatile (SP, SP2) du second appareil (B).

3. Appareil électronique comportant un microprocesseur (MP), une mémoire non volatile (SP) et une interface (I) selon la revendication 1, au moins une ligne (D, T) de transmission de signaux s'étendant à partir de chacun de ces modules (MP, SP, I), et comportant un dispositif de commutation commandable (S), qui est relié aux lignes (D, T) de transmission de signaux du module (MP, SP, I),
**caractérisé en ce**
**que** le dispositif de commutation commandable (S) comporte plusieurs états de commutation possibles, dans lesquels les au moins une ligne (D, T) de transmission de signaux de respectivement au moins deux des trois modules (MP, SP, I) sont reliées entre elles et que le dispositif de commutation commandable (S) peut être commandé par l'intermédiaire de l'interface (I) dans un état de commutation, dans lequel le dispositif de commutation (S) relie la au moins une ligne de transmission de signaux (D, T) de la mémoire non volatile (SP) à l'interface (1).

4. Appareil électronique selon la revendication 3, **caractérisé en ce qu'**un signal logique, appliqué à l'interface (I), commande le dispositif de commutation (S) dans l'état de commutation, dans lequel il relie la au moins une ligne de transmission de signaux (D, T) de la mémoire non volatile (SP) à la au moins une ligne de transmission de signaux (D, T) de l'interface (I).

5. Appareil électronique selon la revendication 3, **caractérisé en ce que** la tension de fonctionnement (U+/U-), appliquée à l'interface (I), d'un autre appareil électronique (A) agencé de la même manière commande le dispositif de commutation (S) dans l'état de commutation, dans lequel il relie la au moins une ligne de transmission de signaux (D, T) de la mémoire non volatile (SP) comportant la au moins une ligne de transmission de signaux (D, T) de l'interface (I).

6. Appareil électronique selon la revendication 3, **caractérisé en ce que** chaque module (MP, SP, I) comporte, en tant que ligne de transmission de signaux, précisément une ligne en série (D) de transmission de données et une ligne (T) de transmission de signaux de cadence.

7. Appareil électronique selon la revendication 3, **caractérisé en ce que** le dispositif de commutation comporte des premiers moyens de commutation (S1) pour commuter la liaison de la au moins une ligne (D, T) de transmission de signaux entre le microprocesseur (MP) et la mémoire non volatile (SP) d'une part et entre le microprocesseur (MP) et l'interface (I) d'autre part, et que ces premiers moyens de commutation (S1) sont commandés par le microprocesseur (MP) par l'intermédiaire d'une ligne pour la commande d'accès (Z1).

8. Appareil électronique selon la revendication 7, **caractérisé en ce que** lorsque le microprocesseur (MP) n'est pas chargé par une tension, l'état de commutation des premiers moyens de commutation (S1) permet la liaison de la au moins une ligne (D, T) de transmission de signaux entre l'interface (I) et la mémoire non volatile (SP).

9. Appareil électronique selon la revendication 3, **caractérisé en ce que** le dispositif de commutation (S) comporte des seconds moyens de commutation (S2), qui permettent la commutation de la liaison entre l'interface (I) et le microprocesseur (MP) d'une part et entre l'interface (I) et la mémoire non volatile (SP) d'autre part.

10. Appareil électronique selon la revendication 9, **caractérisé en ce que** l'état de commutation des seconds moyens de commutation (S2) dépend de l'application d'un signal de tension, d'une source interne de tension de fonction (UB) et/ou de signaux de tension au niveau de l'interface (I) à une seconde ligne pour la commande d'accès (Z2) du dispositif de commutation (S).

11. Appareil électronique selon la revendication 3, **caractérisé en ce que** l'interface (I) possède un circuit de protection et/ou un circuit d'attaque, au moyen desquels la au moins une ligne (D, T) de transmission de signaux est raccordée à une borne extérieure de l'appareil.

12. Appareil électronique selon la revendication 3, **caractérisé en ce qu'**au moins la mémoire non volatile (SP) et le dispositif de commutation (S) peuvent être alimentés, par l'intermédiaire de l'interface (I), d'une tension de fonctionnement externe (U+/U-).

13. Appareil électronique selon la revendication 1, **caractérisé en ce que** l'interface comprend des contacts (KUA, KGNDA, KTA, KDA, KCA ou KUB, KGNDB, KTB, KDB, KCB) et que l'appareil est agencé par ailleurs de telle sorte qu'il peut être connecté directement à un autre appareil identique sans moyens de liaison matérialisés, tels qu'un câble (C), un adaptateur, etc.

14. Appareil électronique selon la revendication 1, **caractérisé en ce que** tous les moyens matériels (12, Z10, R₁₁, R₁₂, R₁₄, R₁₅) , qui constituent la caractéristique de la possibilité de copiage forcé, sont seulement de simples composants électriques comportant respectivement seulement deux bornes de fonctionnement.

15. Appareil électronique selon la revendication 1, **caractérisé en ce qu'**il comporte un rail d'alimentation (18), à partir duquel le microprocesseur ou le microcontrôleur (10) est alimenté en courant, et que ce rail d'alimentation (18) est supporté par un accumulateur d'énergie (3).

16. Appareil électronique selon la revendication 1, **caractérisé en ce qu'**une section de valve (12) est disposée dans la voie s'étendant entre la borne d'alimentation en courant du microprocesseur ou du microcontrôleur (10) et la borne d'alimentation en courant du module de mémoire non volatile.

17. Appareil électronique selon la revendication 1, **caractérisé en ce que** la mémoire non volatile (11) possède une entrée ENABLE- ou NOT_ENABLE/INHIBIT (11.1), dont l'état peut être aussi bien interrogé que positionné par le microprocesseur ou le microcontrôleur.

18. Appareil électronique selon la revendication 17, **caractérisé en ce que** la voie d'action (17) pour l'interrogation et le positionnement de l'entrée ENABLE- ou NOT_{_}ENABLE/INHIBIT (11.1) par une résistance (Z10) ou une source de courant (Z10) est reliée à la borne de tension d'alimentation du microprocesseur ou du microcontrôleur (10).

19. Appareil électronique selon la revendication 1, **caractérisé en ce que** la ligne de transmission de données (13) entre le microprocesseur ou le microcontrôleur (10) et la mémoire non volatile est reliée à un potentiel de référence (GND) par l'intermédiaire d'une résistance terminale (R₁₂).

20. Appareil électronique selon la revendication 16, **caractérisé en ce qu'**au moins une partie du programme d'initialisation du microprocesseur ou du microcontrôleur (10) est mémorisée dans le module de mémoire non volatile (11) pouvant être alimenté en courant à partir de l'interface (KUA, KGNDA, KTA, KDA; KCA).

21. Appareil électronique selon la revendication 1, **caractérisé en ce que** l'interface comporte, en dehors de contacts (KUA, KGNDA, KTA, KDA; KCA), des moyens coopérant avec ces contacts et qui rendent impossible un accès intempestif ou non autorisé à ces contacts.

22. Appareil électronique selon la revendication 21, **caractérisé en ce que** l'appareil (A) comporte un boîtier qui est agencé d'une part en rapport avec son interface (KUA, KGNDA, KTA, KDA; KCA) - et vice-versa - et d'autre part en rapport avec un second appareil identique (B) et son interface (KUB, KGNDB, KTB, KDB; KCB) - et vice-versa - de telle sorte que les deux interfaces peuvent être reliées entre elles uniquement et uniquement par interconnexion des deux appareils (A, B) pour former un seul dispositif fonctionnel monobloc pour la transmission de données entre ces appareils.

23. Procédé pour doubler un premier appareil électronique (B), qui comporte un microprocesseur (MP2), une mémoire non volatile (SP2) et une interface (KUB, KGNDB, KTB, KDB; KCB), l'interface (KUB, KGNDB, KTB, KDB; KCB) étant agencée de telle sorte que cette interface peut être reliée (C) à une interface correspondante (KUA, KGNDA, KTA, KDA; éventuellement également KCA) d'un second appareil électronique (A) agencé (MP1, SP1) de la même manière en ce qui concerne le microprocesseur et la mémoire non volatile, **caractérisé par** les étapes suivantes:
(1) liaison (C) du premier appareil (B) au niveau de son interface (KUB, KGNDB, KTB, KDB; KCB) au second appareil (A) au niveau de son interface (KUA, KGNDA, KTA, KDA; KCA);
(2) chargement des bornes d'alimentation (K10, K11), du second appareil (A) avec la tension normale de fonctionnement de cet appareil;
(3) désactivation initiale par chargement indiqué précédemment du module de mémoire non volatile (11) dans le second appareil (A) et activation immédiate par chargement indiqué précédemment du module de mémoire non volatile (21) dans le premier appareil (B);
(4) détection, du côté du microprocesseur (10) dans le second appareil (A), du fait qu'en dépit d'une désactivation du module de mémoire (11) dans le second appareil (A), un module de mémoire non volatile (21) peut répondre, et déclenchement et exécution de la lecture de données à partir de la mémoire non volatile (21) dans le premier appareil (B) dans une zone de mémoire de travail (10.5) du microprocesseur (10) dans le second appareil (A);
(5) une fois achevée la lecture, contrôle d'un niveau de signal (DATA; U_{R14}), qui est provoqué d'une manière forcée de façon caractéristique au moyen de l'interface (KUB, KGNDB, KTB, KDB; KCB/KUA, KGNDA, KTA, KDA; KCA) par le premier appareil (B) de manière à indiquer de ce fait au microprocesseur (10) dans le second appareil (A) l'existence de la liaison avec le premier appareil (B);
(6) séparation - moyennant le maintien de l'alimentation en courant du second appareil (A) - de l'interface (KUB, KGNDB, KTB, KDB; KCB/KUA, KGNDA, KTA, KDA; KCA) entre les deux appareils (A et B);
(7) identification, au moyen du contrôle de niveau lors de l'étape (5), de la séparation de l'interface (KUB, KGNDB, KTB, KDB; KCB/KUA, KGNDA, KTA, KDA; KCA) en tant que condition de vérité pour une inscription en retour alors possible des données lues auparavant dans ladite zone de mémoire de travail (10.5) du microprocesseur (10) dans le second appareil (A), dans le module de mémoire non volatile (11) du second appareil (A);
(8) déclenchement et exécution de l'écriture en retour desdites données depuis ladite zone de mémoire de travail (10.5) dans le module de mémoire non volatile (11) dans le second appareil (A) et attente jusqu'à ce que ce processus soit terminé.

24. Procédé selon la revendication 23, **caractérisé par** l'étape supplémentaire:
(9) attente jusqu'à ce que le microprocesseur (10) ait à nouveau démarré et/ou que le microprocesseur (10) ait normalement initialisé l'application du second appareil (A) et que l'appareil (A) ait atteint à ce point l'état prêt pour le fonctionnement.

25. Procédé selon la revendication 24, **caractérisé par** l'étape supplémentaire:
(10) contrôle, au cours de l'initialisation, du caractère correct de la transmission de données exécutée, sur la base d'un élément du programme d'initialisation du microprocesseur (10), transmis conjointement à partir de la mémoire non volatile (21) du premier appareil (B) dans la mémoire non volatile (11) du second appareil (A).

26. Procédé selon la revendication 24 ou 25, **caractérisé par** l'étape suivante:
(11) identification, à partir de l'état prêt pour le fonctionnement atteint par le second appareil (A), de . l'état terminé ou de l'état correct de la transmission de données exécutée depuis de la mémoire non volatile (21) du premier appareil (B), dans la mémoire volatile (11) du second appareil (A).

27. Utilisation du procédé selon la revendication 23, lors de ou pour la fabrication d'appareils électroniques.

28. Dispositif comportant deux appareils électroniques agencés de la même manière selon la revendication 3, dans lequel une transmission de données est prévue entre ces appareils, **caractérisé en ce que** les interfaces (I) du premier appareil électronique (A) et du second appareil électronique (B) peuvent être reliées, le premier appareil (A) étant relié à une source de tension de fonctionnement (UB) et le second appareil électronique (B) étant alimenté par l'intermédiaire de l'interface (I) à une tension de fonctionnement (U+/U-) dérivée de la tension de fonctionnement du premier appareil (A), et que sous l'effet de la liaison des deux appareils (A, B), les dispositifs de commutation (S) des deux appareils (A, B) sont amenés chacun dans un état de commutation tel qu'une transmission de données commandée par le microprocesseur (MP) du premier appareil (A) s'effectue depuis la mémoire non volatile (SP) du second appareil (B) en direction de la mémoire non volatile (SP) du premier appareil (A).

29. Dispositif comportant deux appareils électroniques agencés de la même manière selon la revendication 14, dans lequel une transmission de données est prévue entre ces appareils, **caractérisé en ce que** pendant la durée d'écriture d'un bloc de données dans la mémoire non volatile (SP), dans laquelle l'écriture doit être réalisée, le microprocesseur (MP) lit déjà le bloc de données suivant à transmettre à partir de la mémoire non volatile (SP) devant être lue.
